(19) Europäisches Patentamt
European Patent Office
Office européen des brevets

(11) **EP 4 343 869 A1**

# (12) EUROPEAN PATENT APPLICATION
published in accordance with Art. 153(4) EPC

(43) Date of publication:
**27.03.2024 Bulletin 2024/13**

(21) Application number: **22819533.5**

(22) Date of filing: **07.06.2022**

(51) International Patent Classification (IPC):
**H01L 45/00** (2006.01)    **H01L 27/24** (2006.01)

(52) Cooperative Patent Classification (CPC):
**H10B 63/10; H10B 63/20; H10B 63/845;
H10N 70/026; H10N 70/231; H10N 70/826;
H10N 70/8828;** Y02D 10/00

(86) International application number:
**PCT/CN2022/097453**

(87) International publication number:
**WO 2022/257935 (15.12.2022 Gazette 2022/50)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **11.06.2021  CN 202110655982**

(71) Applicant: **Huawei Technologies Co., Ltd.
Longgang
Shenzhen, Guangdong 518129 (CN)**

(72) Inventors:
• **CHEN, Xin
Shenzhen, Guangdong 518129 (CN)**
• **LI, Xiang
Shenzhen, Guangdong 518129 (CN)**

(74) Representative: **Maiwald GmbH
Engineering
Elisenhof
Elisenstrasse 3
80335 München (DE)**

(54) **PHASE-CHANGE MEMORY CELL, PHASE-CHANGE MEMORY, ELECTRONIC DEVICE AND PREPARATION METHOD**

(57)    This application discloses a phase-change storage unit, a phase-change memory, an electronic device, and a preparation method, and relates to the field of semiconductor storage technologies. The phase-change storage unit includes a phase-change thin film. The phase-change thin film includes a phase-change material layer and a heterojunction layer, and the phase-change material layer is in contact with the heterojunction layer. The phase-change material layer is formed by using a phase-change material, and the heterojunction layer is formed by using a heterojunction material. A lattice mismatch degree between the heterojunction material and the phase-change material is less than or equal to 20%, a contact crystal surface of the heterojunction material and a contact crystal surface of the phase-change material have a same lattice angle, and a melting point of the heterojunction material is greater than a melting point of the phase-change material. The phase-change storage unit has advantages such as a simple structure, strong operation reliability, strong stability, a fast read/write speed, and a long lifespan.

**EP 4 343 869 A1**

FIG. 1

## Description

This application claims priority to Chinese Patent Application No. 202110655982.8, filed with the China National Intellectual Property Administration on June 11, 2021 and entitled "PHASE-CHANGE STORAGE UNIT, PHASE-CHANGE MEMORY, ELECTRONIC DEVICE, AND PREPARATION METHOD", which is incorporated herein by reference in its entirety.

## TECHNICAL FIELD

This application relates to the field of semiconductor storage technologies, and in particular, to a phase-change storage unit, a phase-change memory, an electronic device, and a preparation method.

## BACKGROUND

A phase-change memory uses a phase-change material as a storage medium, and the phase-change material can perform reversible conversion between a crystalline state and an amorphous state. The phase-change memory stores data "0" and " 1 " by using a difference between high and low resistivity corresponding to the phase-change material in the amorphous state and the crystalline state. Selection of the phase-change material has important impact on a read/write speed of the phase-change memory.

A related technology provides a superlattice phase-change material. The superlattice phase-change material is formed by alternately stacking a plurality of layers of GeTe thin films and a plurality of layers of $Sb_2Te_3$ thin films, which is conducive to improving the read/write speed of the phase-change memory. However, in an operation process of the superlattice phase-change material, an element Te and an element Sb migrate to different electric field directions. As a result, an Sb-rich region and a Te-rich region are formed inside the phase-change material. This is not conducive to repeated erasing and writing of the superlattice phase-change material, and is easy to reduce a cycle life of the superlattice phase-change material.

## SUMMARY

In view of this, this disclosure provides a phase-change storage unit, a phase-change storage array, a phase-change memory, an electronic device, and a preparation method, to resolve the foregoing technical problem.

Specifically, the following technical solutions are included.

According to one aspect, an embodiment of this disclosure provides a phase-change storage unit, where the phase-change storage unit includes a phase-change thin film. The phase-change thin film includes a phase-change material layer and a heterojunction layer, and the phase-change material layer is in contact with the heterojunction layer.

The phase-change material layer is formed by using a phase-change material, and the heterojunction layer is formed by using a heterojunction material.

A lattice mismatch degree between the heterojunction material and the phase-change material is less than or equal to 20%, a contact crystal surface of the heterojunction material and a contact crystal surface of the phase-change material have a same lattice angle, and a melting point of the heterojunction material is greater than a melting point of the phase-change material.

The phase-change storage unit provided in this embodiment of this disclosure uses the heterojunction layer, and the heterojunction layer is formed by using the heterojunction material. Because the lattice mismatch degree between the heterojunction material and the phase-change material is less than or equal to 20%, and the contact crystal surface of the heterojunction material and the contact crystal surface of the phase-change material have the same lattice angle, the phase-change material layer may crystallize on a surface of the heterojunction layer in an epitaxial growth manner, so that the heterojunction layer can be used as a crystallization template of the phase-change material layer. This accelerates a crystallization speed of the phase-change material, increases a phase-change speed of the phase-change material, and thus increases an operation speed of the phase-change material. Because the melting point of the heterojunction material is greater than the melting point of the phase-change material, when the phase-change material layer undergoes a change in phase, the heterojunction layer maintains a stable crystal structure. This effectively prevents element migration of the phase-change material in an electric field direction, reduces diffusion between the phase-change material and an electrode, and is conducive to improving a cycle life of the phase-change material layer.

In addition, in the phase-change storage unit, the phase-change thin film includes the phase-change material layer and the heterojunction layer. This avoids a surface problem and an operation instability problem that are easily caused by a plurality of layers of surfaces, and it is more conducive to designing the phase-change storage unit to be of a common confined structure. The phase-change storage unit that uses the single-layer phase-change material layer and the single-layer heterojunction layer has a simple structure, and a preparation method thereof is accordingly simple and easy to be implemented. Specifically, compared with a preparation process of a complex multi-layer superlattice structure, a preparation process of the phase-change thin film 1 is easier to be accurately controlled, so that a device yield rate is improved. In addition, an electrical operation of the phase-change thin film 1 of a single-layer structure is easier to be controlled, and more stable resistance distribution may be obtained (while in the multi-layer superlattice structure, element diffusion between phase-change layers is easier to occur, which reduces a cycle operation life of a device).

In this embodiment of this disclosure, a crystal structure of the phase-change material used by the phase-change material layer is similar to a crystal structure of the heterojunction material used by the heterojunction layer, or at least a crystal form of the contact crystal surface of the phase-change material is similar to that of the heterojunction material, so that a higher lattice matching degree is obtained between the phase-change material and the heterojunction material, and the heterojunction material can be further used as a crystallization template of the phase-change material.

In some possible implementations, when the heterojunction material and the phase-change material each are a hexagonal system material, a length difference between an a axis a of the heterojunction material and an a axis a of the phase-change material is less than or equal to 20%.

In some possible implementations, when the heterojunction material is a hexagonal system material, and the phase-change material is a cubic system material, a length of an a axis of the heterojunction material is defined as a, a length of an a axis of the phase-change material is defined as a, and a difference between a and $\sqrt{2}a_2$ is less than or equal to 20%.

In some possible implementations, a thickness of the phase-change material layer is 2 nm to 100 nm, for example, 10 nm, 20 nm, 30 nm, 40 nm, 50 nm, 60 nm, 70 nm, 80 nm, or 90 nm. The thickness of the phase-change material layer 101 may be determined based on a magnitude of an operation voltage or an operation current corresponding to the phase-change material layer 101 when the phase-change material layer 101 undergoes the change in phase.

A thickness of the heterojunction layer is 2 nm to 20 nm, for example, 2 nm, 3 nm, 4 nm, 5 nm, 6 nm, 7 nm, 8 nm, 9 nm, 10 nm, 12 nm, 15 nm, 17 nm, 18 nm, or 19 nm. The foregoing thickness range of the heterojunction layer can effectively prevent element diffusion between the phase-change material layer and the electrode.

In some possible implementations, the phase-change material is one of a doped or an undoped Ge-Te binary compound, a doped or an undoped Sb-Te binary compound, a doped or an undoped Bi-Te binary compound, a doped or an undoped Ge-Sb-Te ternary compound, a doped or an undoped Ga-Sb binary compound, and doped or undoped Sb.

The heterojunction material is an M-Te compound, where M is a transition metal element. The heterojunction material may be $TiTe_2$ (titanium ditelluride), $ZrTe_3$ (zirconium telluride), $PdTe_2$ (palladium ditelluride), CdTe (cadmium telluride), $MoTe_2$ (molybdenum ditelluride), $MnTe_2$ (manganese telluride), $IrTe_2$ (iridium telluride), RnTe (radon telluride), $PtTe_2$ (platinum ditelluride), $Pt_2Te_3$ (diplatinum tritelluride), ScTe (scandium tellu-

ride), $Sc_2Te_3$ (discandium tritelluride), $NiTe_2$ (nickel ditelluride), $TaTe_2$ (tantalum ditelluride), or ZnTe (zinc telluride).

In some possible implementations, M is Ti, Zr, Pd, Cd, Mo, Mn, Ir, Rn, Pt, Sc, Ni, Ta, or Zn.

In some possible implementations, when the phase-change material is a doped material, a doping element is selected from at least one of C, N, Si, B, Sc, Ti, Y, Zr, Hf, V, Ta, W, Cu, Zn, and In.

The phase-change material and the heterojunction material that are of the foregoing types are used in combination, as long as the lattice mismatch degree between the phase-change material and the heterojunction material that are used in combination is less than or equal to 20%, the surfaces of the heterojunction material and the phase-change material that are used in combination have the same lattice angle, and the melting point of the phase-change material used in combination is less than the melting point of the heterojunction material.

In some possible implementations, the phase-change storage unit further includes a bottom electrode layer, a top electrode layer, and an insulation medium layer.

The phase-change thin film is located between the bottom electrode layer and the top electrode layer.

The insulation medium layer is used to provide an insulation isolation function for the phase-change storage unit.

In some possible implementations, the phase-change storage unit further includes an intermediate electrode layer and a gating layer.

A first surface of the intermediate electrode layer is in contact with the phase-change thin film, and a second surface of the intermediate electrode layer is in contact with the gating layer.

The phase-change thin film, the intermediate electrode layer, and the gating layer are located between the bottom electrode layer and the top electrode layer as a whole.

In some possible implementations, the phase-change storage unit is of a confined structure, a T-shaped structure, a U-shaped groove structure, or an L-shaped structure.

In some possible implementations, the phase-change storage unit is of a cylindrical structure, and the phase-change storage unit further includes an inner electrode layer and an outer electrode layer.

The inner electrode layer, the phase-change thin film, and the outer electrode layer are sequentially coated from inside to outside in a radial direction.

In some possible implementations, the inner electrode layer is in a solid cylindrical shape or a circular annular shape.

In some possible implementations, the phase-change storage unit is of a cylindrical structure, and the phase-change storage unit further includes an inner electrode layer, an intermediate electrode layer, a gating layer, and an outer electrode layer.

The inner electrode layer, the phase-change thin film, the intermediate electrode layer, the gating layer, and the outer electrode layer are sequentially coated from inside to outside in a radial direction.

In some possible implementations, the inner electrode layer is in a solid cylindrical shape or a circular annular shape.

According to another aspect, an embodiment of this disclosure provides a phase-change storage array, where the phase-change storage array includes any one of the foregoing phase-change storage units.

According to still another aspect, an embodiment of this disclosure provides a phase-change memory, where the phase-change memory includes the foregoing phase-change storage unit or the foregoing phase-change storage array.

Based on use of the foregoing phase-change storage unit, the phase-change memory provided in this embodiment of this disclosure has at least the following advantages: high stability, good repeatability, a high read/write speed, a high memory density, low costs, and the like.

According to yet another aspect, an embodiment of this disclosure provides an electronic device, where the electronic device includes a processor and the foregoing phase-change memory.

The phase-change memory is configured to store data accessed by the processor.

For example, the electronic device includes but is not limited to a computer, a printer, a mobile phone, a camera, and the like.

According to still yet another aspect, an embodiment of this disclosure provides a preparation method of a phase-change storage unit, where the phase-change storage unit is the foregoing phase-change storage unit.

The preparation method of the phase-change storage unit includes: preparing a phase-change thin film.

The preparing a phase-change thin film includes: forming a phase-change material layer and a heterojunction layer separately, and contacting the phase-change material layer with the heterojunction layer.

In some possible implementations, the phase-change material layer and the heterojunction layer are separately formed by using a thin film deposition process.

In some possible implementations, the thin film deposition process is an atomic layer deposition process, a physical vapor deposition process, a chemical vapor deposition process, or a plasma enhanced chemical vapor deposition process.

## BRIEF DESCRIPTION OF DRAWINGS

FIG. 1 is a schematic structural diagram of an example of a phase-change thin film according to an embodiment of this disclosure;
FIG. 2 is a schematic structural diagram of a first example of a phase-change storage unit of a confined structure according to an embodiment of this disclosure;
FIG. 3 is a schematic structural diagram of a second example of a phase-change storage unit of a confined structure according to an embodiment of this disclosure;
FIG. 4 is a schematic structural diagram of a third example of a phase-change storage unit of a confined structure according to an embodiment of this disclosure;
FIG. 5 is a schematic structural diagram of a fourth example of a phase-change storage unit of a confined structure according to an embodiment of this disclosure;
FIG. 6 is a schematic structural diagram of an example of a phase-change storage unit of a confined structure in which a gating layer is designed based on FIG. 5 according to an embodiment of this disclosure;
FIG. 7 is a schematic structural diagram of a fifth example of a phase-change storage unit of a confined structure according to an embodiment of this disclosure;
FIG. 8 is a schematic structural diagram of an example of a phase-change storage unit of a confined structure in which a gating layer is designed based on FIG. 7 according to an embodiment of this disclosure;
FIG. 9 is a schematic structural diagram of an example of a phase-change storage unit of a T-shaped structure according to an embodiment of this disclosure;
FIG. 10 is a schematic structural diagram of an example of a phase-change storage unit of a T-shaped structure in which a gating layer is designed based on FIG. 9 according to an embodiment of this disclosure;
FIG. 11 is a schematic structural diagram of an example of a phase-change storage unit of a U-shaped groove structure according to an embodiment of this disclosure;
FIG. 12 is a schematic structural diagram of an example of a phase-change storage unit of a U-shaped groove structure in which a gating layer is designed based on FIG. 11 according to an embodiment of this disclosure;
FIG. 13 is a schematic structural diagram of another example of a phase-change storage unit of a U-shaped groove structure according to an embodiment of this disclosure;
FIG. 14 is a schematic structural diagram of an example of a phase-change storage unit of a U-shaped groove structure in which a gating layer is designed based on FIG. 13 according to an embodiment of this disclosure;
FIG. 15 is a schematic structural diagram of an example of a phase-change storage unit of an L-shaped structure according to an embodiment of this disclosure;

FIG. 16 is a schematic structural diagram of an example of a phase-change storage unit of an L-shaped structure in which a gating layer is designed based on FIG. 15 according to an embodiment of this disclosure;

FIG. 17 is a schematic structural diagram of another example of a phase-change storage unit of an L-shaped structure according to an embodiment of this disclosure;

FIG. 18 is a schematic structural diagram of an example of a phase-change storage unit of an L-shaped structure in which a gating layer is designed based on FIG. 17 according to an embodiment of this disclosure;

FIG. 19 is a schematic structural diagram of an example of a phase-change storage unit of a cylindrical structure according to an embodiment of this disclosure;

FIG. 20 is a schematic structural diagram of another example of a phase-change storage unit of a cylindrical structure according to an embodiment of this disclosure;

FIG. 21 is a schematic structural diagram of an example of a phase-change storage array according to an embodiment of this disclosure;

FIG. 22 is a schematic structural diagram of an example of a first intermediate array according to an embodiment of this disclosure;

FIG. 23 is a schematic structural diagram of a second intermediate array formed by filling an insulation medium in a hole drilled on the structure shown in FIG. 22;

FIG. 24 is a top view of another example of a phase-change storage array according to an embodiment of this disclosure;

FIG. 25 is a side view obtained along an AB direction from top to bottom based on FIG. 24;

FIG. 26 is a schematic structural diagram of a thin film formed by alternately stacking a plurality of outer electrode layers and a plurality of insulation medium layers according to an embodiment of this disclosure;

FIG. 27 is a top view of still another example of a phase-change storage array according to an embodiment of this disclosure;

FIG. 28 is a side view obtained along a CD direction from top to bottom based on FIG. 27;

FIG. 29 is a schematic diagram of an application scenario of an example of a phase-change storage unit according to an embodiment of this disclosure; and

FIG. 30 is a schematic diagram of another application scenario of an example of a phase-change storage unit according to an embodiment of this disclosure.

Reference signs respectively indicate:

100-phase-change storage unit,

1-phase-change thin film, 101-phase-change material layer, 102-heterojunction layer,

21-bottom electrode layer, 22-top electrode layer, 23-intermediate electrode layer,

24-inner electrode layer, 25-outer electrode layer,

3-insulation medium layer,

4-gating layer,

200-word line layer, 300-bit line layer,

400-word line, 500-bit line,

600-insulation medium,

700-first metal connection column, 800-second metal connection column,

1001-multi-value phase-change memory,

2001-dynamic random access memory,

3001-cache,

4001-processor, and

5001-solid-state drive.

## DESCRIPTION OF EMBODIMENTS

To make the technical solutions and advantages of this disclosure clearer, the following further describes implementations of this disclosure in detail with reference to the accompanying drawings.

A phase-change memory is a solid-state semiconductor non-volatile memory, has advantages such as high-speed reading, a high quantity of erasable times, non-volatility, a small component size, and low power consumption, and is widely used in products such as a semiconductor memory. The phase-change memory uses a phase-change material as a storage medium, and the phase-change material can perform reversible conversion between a crystalline state and an amorphous state. The phase-change memory stores data "0" and " 1" by using a difference between high and low resistivity corresponding to the phase-change material in the amorphous state and the crystalline state.

A working process of the phase-change memory includes a SET process and a RESET process. The SET process is applying a wide and weak electrical pulse to heat the phase-change material, so that a phase-change material temperature is raised to a value between a crystallizing temperature and a melting temperature, and the phase-change material is crystallized into an ordered state, to form the crystalline state with the low resistivity, to store the data "0". The RESET process is applying a narrow and strong electrical pulse to heat the phase-change material, so that the phase-change material temperature is raised to a value above the melting temperature, and the phase-change material is melted into an unordered state. After a fast cooling quenching process (which is > $10^9$ K/s), the phase-change material directly enters the amorphous state with the high resistivity from a melted state, to store the data "1".

It can be learned that a phase-change speed of the phase-change material directly affects a read/write speed of the phase-change memory. A related technology provides a superlattice phase-change material. The superlattice phase-change material is formed by alternately stacking a plurality of layers of GeTe thin films and a plurality of layers of $Sb_2Te_3$ thin films. This type of superlattice phase-change material has a high phase-change speed.

However, in an operation process of the superlattice phase-change material provided in the related technology, an element Te and an element Sb migrate to different electric field directions. As a result, an Sb-rich region and a Te-rich region are formed inside the phase-change material. This is not conducive to repeated erasing and writing of the superlattice phase-change material, and is easy to reduce a cycle life of the superlattice phase-change material.

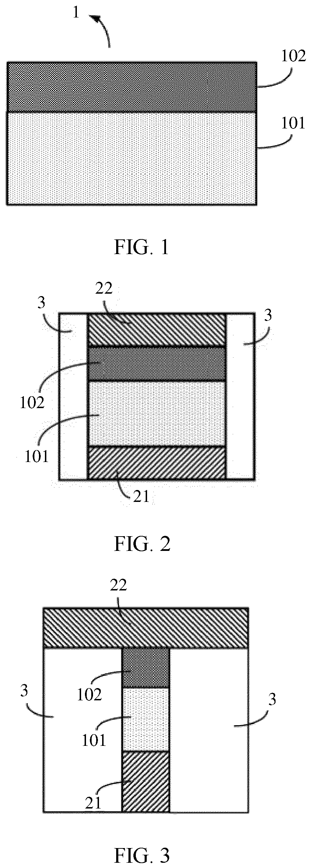

An embodiment of this disclosure provides a phase-change storage unit. The phase-change storage unit includes a phase-change thin film 1. As shown in FIG. 1, the phase-change thin film 1 includes a phase-change material layer 101 and a heterojunction layer 102, and the phase-change material layer 101 is in contact with the heterojunction layer 102.

The phase-change material layer 101 is formed by using a phase-change material, and the heterojunction layer 102 is formed by using a heterojunction material, where (1) A lattice mismatch degree between the heterojunction material and the phase-change material is less than or equal to 20%. (2) A contact crystal surface of the heterojunction material and a contact crystal surface of the phase-change material have a same lattice angle. (3) A melting point of the heterojunction material is greater than a melting point of the phase-change material.

The contact crystal surface in the foregoing "A contact crystal surface of the heterojunction material and a contact crystal surface of the phase-change material have a same lattice angle" is a crystal surface used for contact between the phase-change material layer 101 and the heterojunction layer 102.

The phase-change storage unit provided in this embodiment of this disclosure uses the heterojunction layer 102, and the heterojunction layer 102 is formed by using the heterojunction material. Because the lattice mismatch degree between the heterojunction material and the phase-change material is less than or equal to 20%, and the contact crystal surface of the heterojunction material and the contact crystal surface of the phase-change material have the same lattice angle, the phase-change material layer 101 may crystallize on a surface of the heterojunction layer 102 in an epitaxial growth manner, so that the heterojunction layer 102 can be used as a crystallization template of the phase-change material layer 101. This accelerates a crystallization speed of the phase-change material, increases a phase-change speed of the phase-change material, and thus increases an operation speed of the phase-change material. Because the melting point of the heterojunction material is greater than the melting point of the phase-change material, when the phase-change material layer 101 undergoes a change in phase, the heterojunction layer 102 maintains a stable crystal structure. This effectively prevents element migration of the phase-change material in an electric field direction, reduces diffusion between the phase-change material and an electrode, and is conducive to improving a cycle life of the phase-change material layer 101.

In addition, in the phase-change storage unit, the phase-change thin film 1 includes the phase-change material layer 101 and the heterojunction layer 102. This avoids a surface problem and an operation instability problem that are easily caused by a plurality of layers of surfaces, and it is more conducive to designing the phase-change storage unit to be of a common confined structure. The phase-change storage unit that uses the single-layer phase-change material layer 101 and the single-layer heterojunction layer 102 has a simple structure, and a preparation method thereof is accordingly simple and easy to be implemented. Specifically, compared with a preparation process of a complex multi-layer superlattice structure, a preparation process of the phase-change thin film 1 is easier to be accurately controlled, so that a device yield rate is improved. In addition, an electrical operation of the phase-change thin film 1 of a single-layer structure is easier to be controlled, and more stable resistance distribution may be obtained (while in the multi-layer superlattice structure, element diffusion between phase-change layers is easier to occur, which reduces a cycle operation life of a device).

In this embodiment of this disclosure, a crystal structure of the phase-change material used by the phase-change material layer 101 is similar to a crystal structure of the heterojunction material used by the heterojunction layer 102, or at least a crystal form of the contact crystal surface of the phase-change material is similar to that of the heterojunction material, so that a higher lattice matching degree is obtained between the phase-change material and the heterojunction material, and the heterojunction material can be further used as a crystallization template of the phase-change material.

For example, the lattice mismatch degree between the phase-change material and the heterojunction material is less than or equal to 19%, less than or equal to 18%, less than or equal to 17%, less than or equal to 16%, less than or equal to 15%, less than or equal to 14%, less than or equal to 13%, less than or equal to 12%, less than or equal to 11%, less than or equal to 10%, less than or equal to 9%, less than or equal to 8%, less than or equal to 9%, less than or equal to 7%, less than or equal to 6%, and less than or equal to 5%, so that the phase-change material obtains a faster crystallization speed.

When the lattice mismatch degree between the phase-change material and the heterojunction material is less than or equal to 10%, a smaller lattice constant difference exists between the phase-change material and the heterojunction material, so that greater power can be provided for crystallization of the phase-change material, and stability of a crystalline structure formed during the crystallization of the phase-change material is further improved.

In some possible implementations, the heterojunction material and the phase-change material each are a hexagonal system material. For the hexagonal system material, a length of an a axis = a length of a b axis ≠ a length of a c axis, an included angle between the a axis and the b axis is 120°, and an included angle between the a axis and the c axis and an included angle between the b axis and the c axis are both 90°. When the heterojunction material and the phase-change material each are the hexagonal system material, a length difference between an a axis of the heterojunction material and an a axis of the phase-change material is less than or equal to 20% (where the length difference herein is the foregoing lattice mismatch degree).

In some possible implementations, the heterojunction material is a hexagonal system material, and the phase-change material is a cubic system material. For the hexagonal system material, as described above, the length of the a axis = the length of the b axis ≠ the length of the c axis, the included angle between the a axis and the b axis is 120°, and the included angle between the a axis and the c axis and the included angle between the b axis and the c axis are both 90°. For the cubic system material, a length of an a axis = a length of a b axis = a length of a c axis, and any two adjacent axes are perpendicular to each other. In this embodiment of this disclosure, a length of the a axis of the heterojunction material is defined as $a_1$, a length of the a axis of the phase-change material is defined as $a_2$. When the heterojunction material is the hexagonal system material, and the phase-change material is the cubic system material, a difference between $a_1$ and $\sqrt{2}a_2$ is less than or equal to 20% (where the difference between $a_1$ and $\sqrt{2}a_2$ is also the foregoing lattice mismatch degree).

$$\sqrt{2} = 1.4142135623731\ldots.$$

In this embodiment of this disclosure, a thickness range of the phase-change material layer 101 in the phase-change thin film 1 is 2 nm to 100 nm, for example, 10 nm, 20 nm, 30 nm, 40 nm, 50 nm, 60 nm, 70 nm, 80 nm, or 90 nm. A thickness of the phase-change material layer 101 may be determined based on a magnitude of an operation voltage or an operation current corresponding to the phase-change material layer 101 when the phase-change material layer 101 undergoes the change in phase.

In this embodiment of this disclosure, a thickness range of the heterojunction layer 102 in the phase-change thin film 1 is 2 nm to 20 nm, for example, 2 nm, 3 nm, 4 nm, 5 nm, 6 nm, 7 nm, 8 nm, 9 nm, 10 nm, 12 nm, 15 nm, 17 nm, 18 nm, or 19 nm. The foregoing thickness range of the heterojunction layer 102 can effectively prevent element diffusion between the phase-change material layer 101 and the electrode.

In this embodiment of this disclosure, the thickness of the phase-change material layer 101 and a thickness of the heterojunction layer 102 are within the foregoing range, so that the phase-change storage unit can be applicable to a plurality of types of phase-change memories, and a wide adjustment range is obtained.

In some possible implementations, the phase-change material is one of a doped or an undoped Ge-Te binary compound, a doped or an undoped Sb-Te binary compound (for example, $Sb_2Te_3$), a doped or an undoped Bi-Te binary compound, a doped or an undoped Ge-Sb-Te ternary compound, a doped or an undoped Ga-Sb binary compound, and doped or undoped Sb.

The phase-change material may not be doped with any other element, or may be doped with another element. When the phase-change material is a doped material, a doping element that is doped in the phase-change material is selected from at least one of C, N, Si, B, Sc, Ti, Y, Zr, Hf, V, Ta, W, Cu, Zn, and In. An atomic percent content of the doping element in the phase-change material is less than or equal to 20%, for example, 15%, 12%, 10%, 9%, 8%, 7%, 6%, 5%, 4%, 3%, 2%, or 1%.

When the phase-change material is selected from the foregoing types, a heterojunction material that adapts to these phase-change materials is an M-Te compound, where M is a transition metal element. For example, M is Ti, Zr, Pd, Cd, Mo, Mn, Ir, Rn, Pt, Sc, Ni, Ta, or Zn.

In other words, the heterojunction material may be $TiTe_2$ (titanium ditelluride), $ZrTe_3$ (zirconium telluride), $PdTe_2$ (palladium ditelluride), CdTe (cadmium telluride), $MoTe_2$ (molybdenum ditelluride), $MnTe_2$ (manganese telluride), $IrTe_2$ (iridium telluride), RnTe (radon telluride), $PtTe_2$ (platinum ditelluride), $Pt_2Te_3$ (diplatinum tritelluride), ScTe (scandium telluride), $Sc_2Te_3$ (discandium tritelluride), $NiTe_2$ (nickel ditelluride), $TaTe_2$ (tantalum ditelluride), or ZnTe (zinc telluride).

The heterojunction material of the foregoing types has a stable crystal structure, which can effectively prevent element diffusion of the phase-change material in an electric field direction. In addition, on a premise that the lattice mismatch degree between the heterojunction material and the phase-change material is less than or equal to 20%, the phase-change material layer 101 can use the heterojunction material layer 102 as a crystallization growth template, which is conducive to significantly reducing a crystallization time and improving the phase-change speed of the phase-change material.

In addition, in this embodiment of this disclosure, use of the heterojunction layer 102 further requires that high and low resistance identification of the phase-change material layer 101 be not affected, to ensure data accuracy. For example, when the heterojunction layer 102 is thin, no higher requirement is imposed on conductivity of the heterojunction material, because the thin heterojunction layer 102 commonly does not affect resistance identification of the phase-change material layer 101. When the heterojunction layer 102 is thick, a heterojunction material having conductivity may be used, to ensure that the high and low resistance identification of the phase-change material layer 101 is not affected, and ensure the data accuracy.

The phase-change material and the heterojunction material that are of the foregoing types are used in combination, as long as the lattice mismatch degree between the phase-change material and the heterojunction material that are used in combination is less than or equal to 20%, the surfaces of the heterojunction material and the phase-change material that are used in combination have the same lattice angle, and the melting point of the phase-change material used in combination is less than the melting point of the heterojunction material.

For example, an embodiment of this disclosure provides such a phase-change thin film 1, including a single-layer phase-change material layer 101 formed by using a $Sb_2Te_3$ binary compound and a single-layer heterojunction layer 102 formed by using an ScTe compound.

The following describes an example of a preparation method of the phase-change thin film 1 in this embodiment of this disclosure:

When forming the phase-change thin film 1, form the phase-change material layer 101 and the heterojunction layer 102 separately, and contact the phase-change material layer 101 with the heterojunction layer 102. A process includes: First form the phase-change material layer 101, and then form the heterojunction layer 102 on the phase-change material layer 101; or first form the heterojunction layer 102, and then form the phase-change material layer 101 on the heterojunction layer 102.

When forming the phase-change material layer 101, form the phase-change material layer 101 by using the foregoing phase-change material and by using a thin film deposition process. When forming the heterojunction layer 102, form the heterojunction layer 102 by using the foregoing heterojunction material and by using the thin film deposition process.

For example, the thin film deposition process applicable to this embodiment of this disclosure includes but is not limited to the following: an atomic layer deposition (atomic layer deposition, ALD) process, a physical vapor deposition (Physical Vapor Deposition, PVD) process, and a chemical vapor deposition (Chemical Vapor Deposition, CVD) process, for example, a plasma enhanced chemical vapor deposition (Plasma Enhanced Chemical Vapor Deposition, PECVD) process, a magnetron sputtering process, and an electron beam evaporation process.

The magnetron sputtering is a type of the physical vapor deposition process, and has advantages such as being easy to control, a large film coating area, strong adhesion, and a wide range of preparation objects. For example, in this embodiment of this disclosure, the magnetron sputtering process may be used to form the phase-change material layer 101 and the heterojunction layer 102.

Sputtering gas used in the magnetron sputtering process includes but is not limited to at least one of argon Ar, krypton Kr, xenon Xe, neon Ne, and nitrogen $N_2$. Because argon is low in price and is easy to obtain, argon Ar may be selected as working gas for magnetron sputtering.

In this embodiment of this disclosure, the phase-change thin film 1 can be formed by using the magnetron sputtering process, a bottom electrode layer 21 and a top electrode layer 22 can also be formed by using the magnetron sputtering process. When the magnetron sputtering process is used to form the phase-change thin film 1, radio frequency magnetron sputtering is used, and a substrate temperature, that is, a temperature of a sample bench, is 150°C to 350°C, for example, 200°C, 250°C, or 300°C. When the magnetron sputtering process is used to form an electrode layer, direct current power sputtering is used, and the substrate temperature is 20°C to 40°C, for example, 25°C, 30°C, or 35°C.

Based on use of any one of the foregoing phase-change thin films 1, a phase-change storage unit further provided in an embodiment of this disclosure has at least the following advantages.

(1) The lattice mismatch degree between the phase-change material and the heterojunction material is less than or equal to 20%, and particularly, is less than or equal to 10%. In this way, the phase-change material layer 101 may crystallize on the surface of the heterojunction layer 102 in an epitaxial growth manner. Using the heterojunction layer 102 as the crystallization growth template is conducive to significantly reducing the crystallization time, improving the phase-change speed of the phase-change material, and thus improving the read/write speed of the phase-change memory.

(2) The melting point of the phase-change material is less than the melting point of the heterojunction material. When the phase-change material layer 101 undergoes the change in phase, the heterojunction layer 102 maintains the stable crystal structure. This effectively prevents the element migration of the phase-change material in an electric field direction, and is conductive to improving a cycle life of the phase-change material, and thus improves a cycle life of the phase-change storage unit.

In some possible implementations, an embodiment of this disclosure provides such a phase-change storage unit. As shown in FIG. 2, in addition to the foregoing phase-change thin film 1, the phase-change storage unit further includes a bottom electrode layer 21, a top electrode layer 22, and an insulation medium layer 3. The phase-change thin film 1 is located between the bottom electrode layer 21 and the top electrode layer 22.

The insulation medium layer 3 is used to provide insulation isolation for the phase-change storage unit. In other words, when a plurality of phase-change storage units are used at the same time, the insulation medium layer 3 is used to isolate the plurality of phase-change storage units from each other.

In the foregoing phase-change storage unit, that the phase-change material layer 101 and the heterojunction layer 102 are disposed in a stacked manner in an up-down direction includes: The phase-change material layer 101 is located at an upper layer, and the heterojunction layer 102 is located at a lower layer; and the phase-change material layer 101 is located at a lower layer, and the heterojunction layer 102 is located at an upper layer.

Arrangement of the insulation medium layer 3 may be adaptively designed based on a specific structure of the phase-change storage unit, as long as it is ensured that the phase-change storage unit where the insulation medium layer 3 is located can be isolated by using the insulation medium layer 3.

In this embodiment of this disclosure, a substrate may be used to provide support for an entire phase-change storage unit structure. The phase-change storage unit is applied to the substrate, as long as the bottom electrode layer 21 is located on a surface of the substrate. To describe the structure of the phase-change storage unit clearer, in this embodiment of this disclosure, a direction in which the phase-change storage unit is close to the substrate is defined as a bottom direction, and a direction in which the phase-change storage unit is away from the substrate is defined as a top direction.

For example, a material of the substrate may be a common substrate material in the art. For example, the material of the substrate includes but is not limited to: silicon dioxide, silicon carbide, a silicon wafer, sapphire, carbite, and the like.

In application, an organic solvent such as ethanol and/or acetone may be used to clean the surface of the substrate, to remove impurities such as organic substances, oxides, and metal ions on the surface of the substrate. After the cleaning is completed, the substrate may be placed in an oven to dry at 60°C to 90°C, to obtain a fully dry and clean substrate.

In the phase-change storage unit provided in this embodiment of this disclosure, both the top electrode layer 22 and the bottom electrode layer 21 may be prepared by using common electrode materials in the art. The electrode materials need to meet the following requirements: A melting point of the material is higher than a melting point of a phase-change material, and the material is not easy to oxidize. For example, materials of the top electrode layer 22 and the bottom electrode layer 21 include but are not limited to: tungsten titanium TiW (for example, $Ti_3W_7$), tungsten W, aluminum Al, titanium nitride TiN, titanium Ti, tantalum Ta, argentum Ag, platinum Pt, carbon C, cuprum Cu, ruthenium Ru, aurum Au, cobalt Co, chromium Cr, nickel Ni, iridium Ir, palladium Pd, rhodium Rh, and the like.

Based on the foregoing electrode material, the electrode material may be deposited into the top electrode layer 22 or the bottom electrode layer 21 by using a process such as a physical vapor deposition (Physical Vapor Deposition, PVD) process (such as a magnetron sputtering process).

In the phase-change storage unit provided in this embodiment of this disclosure, functions of the insulation medium layer 3 include at least the following: (1) An insulation accommodating hole is formed, so that the phase-change material layer 101 and/or the heterojunction layer 102 in the phase-change thin film 1 are/is limited in the insulation accommodating hole, to reduce heat required for a change in phase; and it is conducive to reducing power consumption of a phase-change memory. (2) A short circuit between the bottom electrode layer 21 and the top electrode layer 22 can be avoided. Therefore, insulation and heat insulation material used by the insulation medium layer 3 needs a high melting point to effectively prevent diffusion of the phase-change material, and further needs better stability in hot environment to maintain good insulation and heat insulation performance when the phase-change material undergoes the change in phase.

For example, the insulation and heat insulation material used by the insulation medium layer 3 includes but is not limited to: silicon nitride $Si_3N_4$, silicon dioxide $SiO_2$, and the like. The insulation and heat insulation material may be deposited into the insulation medium layer 3 by using a process such as a chemical vapor deposition (Chemical Vapor Deposition, CVD) process, for example, a plasma enhanced chemical vapor deposition (Plasma Enhanced Chemical Vapor Deposition, PECVD) process.

Further, the phase-change storage unit provided in this embodiment of this disclosure further includes an intermediate electrode layer 23 and a gating layer 4. A first surface of the intermediate electrode layer 23 is in contact with the phase-change thin film 1, and a second surface of the intermediate electrode layer 23 is in contact with the gating layer 4. The phase-change thin film 1, the intermediate electrode layer 23, and the gating layer 4 are located between the bottom electrode layer 21 and the top electrode layer 22 as a whole. The gating layer 4 is disposed and used as a switch, so that a leakage current can be effectively suppressed.

For example, a material of the intermediate electrode layer 23 includes but is not limited to the following: tungsten titanium TiW (for example, $Ti_3W_7$), tungsten W, aluminum Al, titanium nitride TiN, titanium Ti, tantalum Ta, argentum Ag, platinum Pt, carbon C, cuprum Cu, ruthenium Ru, aurum Au, cobalt Co, chromium Cr, nickel Ni, iridium Ir, palladium Pd, rhodium Rh, and the like. Based on the foregoing electrode material, the intermediate electrode layer 23 may be obtained through deposition by using a magnetron sputtering process.

The foregoing phase-change storage unit provided in this embodiment of this disclosure may be designed into a plurality of structures. For example, a structure of this type of phase-change storage unit includes but is not limited to the following: (1) a confined structure, (2) a T-shaped structure, (3) a U-shaped groove structure, (4) an L-shaped structure, and the like. The following separately provides descriptions by using examples.

(11) In an example, an embodiment of this disclosure provides a phase-change storage unit of a confined structure. As shown in FIG. 2, in a top-bottom direction, a top electrode layer 22, a phase-change thin film 1, a bottom electrode layer 21, and a substrate (where the substrate is not shown in the figure) are in contact sequentially. In other words, the bottom electrode layer 21 is formed on a top surface of the substrate, the phase-change thin film 1 is formed on a top surface of the bottom electrode layer 21, and the top electrode layer 22 is formed on a top surface of the phase-change thin film 1.

An insulation medium layer 3 coats at least a side of the phase-change thin film 1. For example, as shown in FIG. 2, the insulation medium layer 3 coats outsides of the phase-change thin film 1, the bottom electrode layer 21, and the top electrode layer 22. Alternatively, as shown in FIG. 3, the insulation medium layer 3 coats outsides of the phase-change thin film 1 and the bottom electrode layer 21, and tops of the insulation medium layer 3 and the phase-change thin film 1 are both connected to the top electrode layer 22.

The phase-change thin film 1 includes a phase-change material layer 101 and a heterojunction layer 102 that are stacked together in an up-down direction, where the phase-change material layer 101 and the heterojunction layer 102 may be used as any one of an upper layer or a lower layer. For example, as shown in FIG. 2 or FIG. 3, the heterojunction layer 102 may be located between the phase-change material layer 101 and the top electrode layer 22; or the phase-change material layer 101 may be located between the heterojunction layer 102 and the top electrode layer 22 (which is not shown in the figure).

In some examples, as shown in FIG. 3, both the phase-change material layer 101 and the heterojunction layer 102 have a same structure and size. For example, both the two layers have cylindrical structures of a same diameter.

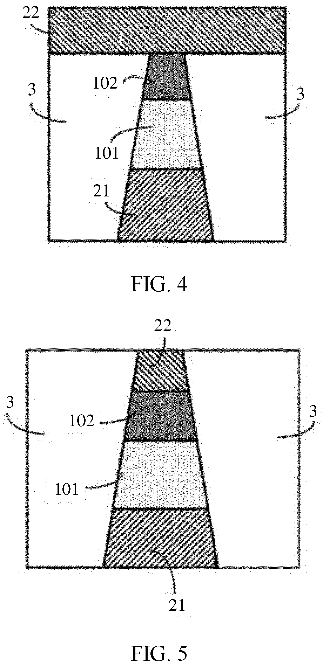

In some examples, structures of the phase-change material layer 101 and the heterojunction layer 102 are the same, but sizes of the two layers are different. For example, the two layers have frustum of a cone shape structure of different sizes. For example, as shown in FIG. 4, the heterojunction layer 102, the phase-change material layer 101, and the bottom electrode layer 21 are sequentially stacked in an up-down direction and are all in a frustum of a cone shape, and radial sizes of the two layers gradually increase. As shown in FIG. 5, the top electrode layer 22, the heterojunction layer 102, the phase-change material layer 101, and the bottom electrode layer 21 are sequentially stacked in an up-down direction and are all in a frustum of a cone shape, and radial sizes of the three layers gradually increase.

The phase-change storage unit of the foregoing confined structure may be prepared by using the following method.

Step 1101: Provide a clean substrate, and form the bottom electrode layer 21 on a surface of the substrate.

Step 1102: Form the insulation medium layer 3 on surfaces of the substrate and the bottom electrode layer 21, and make the insulation medium layer 3 coat the bottom electrode layer 21 and the substrate and be deposited to be of a specific thickness; then, etch the insulation medium layer 3, to etch off a part that is of the insulation medium layer 3 and that corresponds to an insulation accommodating hole; and expose the bottom electrode layer 21, to form the insulation accommodating hole on the insulation medium layer 3.

Step 1103: Form the phase-change thin film 1 in the insulation accommodating hole based on a preparation method of the phase-change thin film 1. For example, the phase-change material layer 101 is formed on the bottom electrode layer 21 in the insulation accommodating hole, and then the heterojunction layer 102 continues to be formed on the phase-change material layer 101 in the accommodating hole, to obtain the phase-change thin film 1.

Step 1104: Form the top electrode layer 22 on top surfaces of the phase-change thin film 1 and the insulation medium layer 3, to obtain a phase-change storage unit.

Further, a gating layer may be further designed in the foregoing phase-change storage unit of the confined structure. The following describes a structure of a phase-change storage unit in which the gating layer is designed as an example.

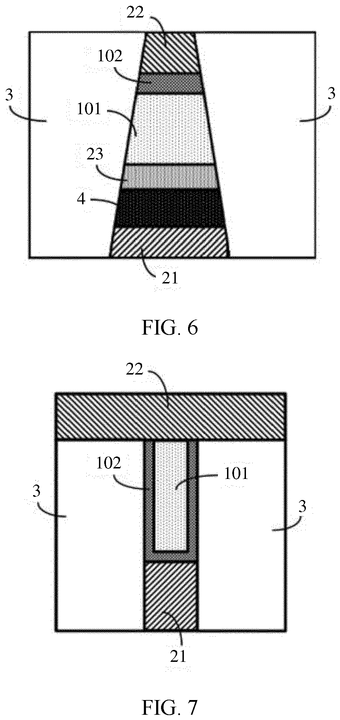

FIG. 6 shows a structure of a phase-change storage unit when the phase-change thin film 1 is of a frustum of a cone shape structure. As shown in FIG. 6, in addition to the top electrode layer 22, the phase-change thin film 1, and the bottom electrode layer 21, the phase-change storage unit of the confined structure may further include an intermediate electrode layer 23 and a gating layer 4, where a first surface of the intermediate electrode layer 23 is in contact with the phase-change thin film 1, and a second surface of the intermediate electrode layer 23 is in contact with the gating layer 4. The phase-change thin film 1, the intermediate electrode layer 23, and the gating layer 4 are located between the bottom electrode layer 21 and the top electrode layer 22 as a whole. When the phase-change thin film 1 is of a cylindrical structure, arrangement of the intermediate electrode layer 23 and arrangement of the gating layer 4 are the same as the foregoing descriptions, and details are not described herein again.

For example, as shown in FIG. 6, in an up-down direction, the top electrode layer 22, the heterojunction layer 102, the phase-change material layer 101, the intermediate electrode layer 23, the gating layer 4, and the bottom electrode layer 21 are sequentially disposed in a stacked manner. In the phase-change storage unit in which the gating layer 4 is designed, in addition to the added gating layer 4 and the added intermediate electrode layer 23, for arrangement of the top electrode layer 22 and arrangement of the phase-change thin film 1, refer to the foregoing descriptions. Details are not described herein again.

When the phase-change storage unit includes the gating layer 4, the preparation method of the phase-change storage unit of the confined structure further includes: Adaptively form the gating layer 4 and the intermediate electrode layer 23 based on specific arrangement of the gating layer 4 and specific arrangement of the intermediate electrode layer 23 in the phase-change storage unit.

For example, as shown above, step 1101 and step 1102 are sequentially performed, and then step 1103 is changed. In this way, step 1103 includes: In the insulation accommodating hole, first form the gating layer 4 on the bottom electrode layer 21, and then sequentially deposit the intermediate electrode layer 23, the phase-change material layer 101, and the heterojunction layer 102. In this way, the gating layer 4, the intermediate electrode layer 23, and the phase-change thin film 1 are disposed in a stacked manner and filled in the insulation accommodating hole. Finally, step 1104 is performed, and step 1104 is shown above.

(12) For example, an embodiment of this disclosure provides a phase-change storage unit of a confined structure. In a top-bottom direction, a top electrode layer 22, a phase-change thin film 1, and a bottom electrode layer 21 are in contact sequentially. In other words, the bottom electrode layer 21 is formed on a top surface of a substrate, the phase-change thin film 1 is formed on a top surface of the bottom electrode layer 21, and the top electrode layer 22 is formed on a top surface of the phase-change thin film 1.

As shown in FIG. 7, a phase-change material layer 101 and a heterojunction layer 102 in the phase-change thin film 1 are disposed in a manner of coating inside and outside. For example, the heterojunction layer 102 coats a bottom and a side of the phase-change material layer 101, and the heterojunction layer 102 is flush with a top surface of the phase-change material layer 101. Alternatively, the phase-change material layer 101 coats a bottom and a side of the heterojunction layer 102, and the phase-change material layer 101 is flush with a top surface of the heterojunction layer 102 (which is not shown in the figure). In this example, the phase-change thin film 1 may be of a cylindrical structure, or may be of a frustum of a cone shape structure.

An insulation medium layer 3 coats at least a side of the phase-change thin film 1. For example, as shown in FIG. 7, the insulation medium layer 3 coats outsides of the phase-change thin film 1 and the bottom electrode layer 21, and a top of the insulation medium layer 3 is in contact with a bottom of the top electrode layer 22; or the insulation medium layer 3 coats the outside of the phase-change thin film 1, and the insulation medium layer 3 is further located between the bottom electrode layer 21 and the top electrode layer 22.

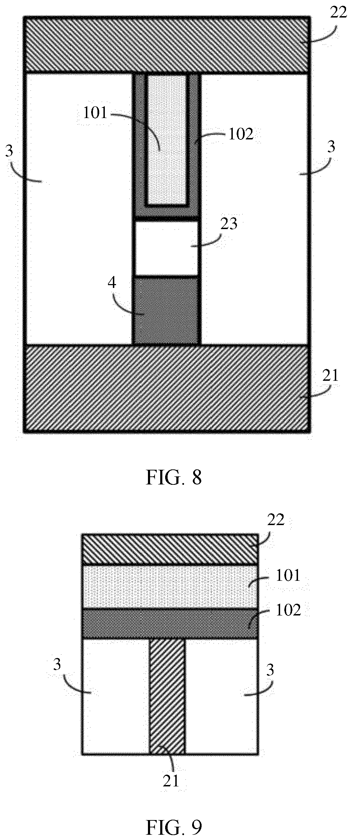

Further, as shown in FIG. 8, the phase-change storage unit of the confined structure in this example may further include an intermediate electrode layer 23 and a gating layer 4. A first surface of the intermediate electrode layer 23 is in contact with the phase-change thin film 1, and a second surface of the intermediate electrode layer 23 is in contact with the gating layer 4. The phase-change thin film 1, the intermediate electrode layer 23, and the gating layer 4 are located between the bottom electrode layer 21 and the top electrode layer 22 as a whole. For example, in an up-down direction, the top electrode layer 22, the phase-change thin film 1, the intermediate electrode layer 23, the gating layer 4, and the bottom electrode layer 21 are sequentially disposed in a stacked manner.

The phase-change storage unit of the foregoing confined structure may be prepared by using the following method.

Step 1201: Provide a clean substrate, and form the bottom electrode layer 21 on a surface of the substrate.

Step 1202: Form the insulation medium layer 3 on surfaces of the substrate and the bottom electrode layer 21, and make the insulation medium layer 3 coat the bottom electrode layer 21 and the substrate and be deposited to be of a specific thickness; then, etch the insulation medium layer 3, to etch off a part that is of the insulation medium layer 3 and that corresponds to an insulation accommodating hole; and expose the bottom electrode layer 21. In this way, the insulation accommodating hole can be formed on the insulation medium layer 3.

Step 1203: Form the phase-change thin film 1 in the insulation accommodating hole based on a preparation method of the phase-change thin film 1. For example, the heterojunction layer 102 is formed on the bottom electrode layer 21 in the insulation accommodating hole, and then the heterojunction layer 102 is etched to form a groove on the heterojunction layer 102, and the phase-change material layer 101 continues to be formed in the groove. In this way, the heterojunction layer 102 coats the bottom and the side of the phase-change material layer 101, to obtain the phase-change thin film 1.

Step 1204: Form the top electrode layer 22 on top surfaces of the phase-change thin film 1 and the insulation medium layer 3, to obtain the phase-change storage unit.

When the phase-change storage unit includes the gating layer 4, the preparation method of the phase-change storage unit of the confined structure further includes: Adaptively form the gating layer 4 and the intermediate electrode layer 23 based on specific arrangement of the gating layer 4 and specific arrangement of the intermediate electrode layer 23 in the phase-change storage unit.

For example, as shown above, step 1201 and step 1202 are sequentially performed, and then adaptive improvement is made when step 1203 is performed. In this way, step 1203 includes: In the insulation accommodating hole, first form the gating layer 4 on the bottom electrode layer 21, and then continue to form the intermediate electrode layer 23 on the gating layer 4; then, continue to form the heterojunction layer 102 on the intermediate electrode layer 23 in the insulation accommodating hole; and etch the heterojunction layer 102, form the groove on the heterojunction layer 102, and continue to form the phase-change material layer 101 in the groove, to obtain the phase-change thin film 1. Finally, step 1204 is performed, and step 1204 is shown above.

(2) In some possible implementations, an embodiment of this disclosure provides a phase-change storage unit of a T-shaped structure. As shown in FIG. 9, the phase-change storage unit of the T-shaped structure includes a phase-change thin film 1, a bottom electrode layer 21, a top electrode layer 22, and an insulation medium layer 3. The insulation medium layer 3 is located on a substrate, the insulation medium layer 3 has a through via, and the bottom electrode layer 21 is located in the through via. The top electrode layer 22, the phase-change thin film 1, and the insulation medium layer 3 are in contact sequentially, the phase-change thin film 1 is further connected to the bottom electrode layer 21, and the bottom electrode layer 21 and the phase-change thin film 1 cooperate to form the T-shaped structure.

In other words, the bottom electrode layer 21 is formed in the through via of the insulation medium layer 3, the phase-change thin film 1 is formed on top surfaces of the bottom electrode layer 21 and the insulation medium layer 3, and the top electrode layer 22 is formed on a top surface of the phase-change thin film 1.

The phase-change thin film 1 includes a phase-change material layer 101 and a heterojunction layer 102 that are stacked together in an up-down direction, where the phase-change material layer 101 and the heterojunction layer 102 may be used as any one of an upper layer or a lower layer. For example, the heterojunction layer 102 may be located between the phase-change material layer 101 and the top electrode layer 22, or the phase-change material layer 101 may be located between the heterojunction layer 102 and the top electrode layer 22.

In some examples, the phase-change material layer 101, the heterojunction layer 102, and the top electrode layer 22 have a same structure and size, for example, all the three layers have cylindrical structures of a same diameter.

For the phase-change storage unit of the T-shaped structure shown in FIG. 9, a thickness of the phase-change material layer 101 may be 20 nm to 150 nm, a thickness of the heterojunction layer 101 may be 4 nm to 20 nm, and a thickness of the top electrode layer 22 may be 50 nm to 300 nm.

In some examples, the phase-change storage unit of the T-shaped structure shown in FIG. 9 may be prepared by using the following method:

Provide a substrate including the bottom electrode layer 21 and the insulation medium layer 3, where a material of the bottom electrode layer 21 may be W.

Clean the substrate by alternately using acetone and ethanol, to remove various impurities such as organic substances, oxides, and metal ions on a surface of the substrate; and bake the substrate in an oven for 20 minutes at 80°C, so that the substrate is fully dry.

Grow the phase-change material layer 101 of an 8 nm thickness, the heterojunction layer 102 of a 50 nm thickness, and the top electrode layer 22 of a 50 nm thickness sequentially by using a magnetron sputtering method.

Etch each film layer above the insulation medium layer 3 by using a photoetching and etching process until the insulation medium layer 3 is exposed, to physically isolate parts of phase-change storage units on tops of different bottom electrode layers 21.

In this example, materials of the bottom electrode layer 21 and the top electrode layer 22 are both TiN, and an operation parameter of magnetron sputtering is: A sputtering power supply is a DC power supply, a sputtering background vacuum is $8 \times 10^{-5}$ Pa to $2 \times 10^{-4}$ Pa, sputtering gas is Ar, and a sputtering atmospheric pressure is 3 mTorr to 6 mTorr.

A magnetron sputtering parameter of the heterojunction layer 101 and the phase-change material layer 102 is: A substrate temperature is 150°C to 300°C during sputtering. The heterojunction layer 101 uses an ScTe target material, and a sputtering power is 10 W to 20 W. The phase-change material layer uses an $Sb_2Te_3$ target material, and a sputtering power is 7 W to 30 W. A magnetron sputtering parameter of the top electrode layer 22 is: A substrate temperature is 20°C to 40°C, a TiN target material is used, and a sputtering power is 50 W to 250 W. In addition, the etching process in this example is reactive-ion etching.

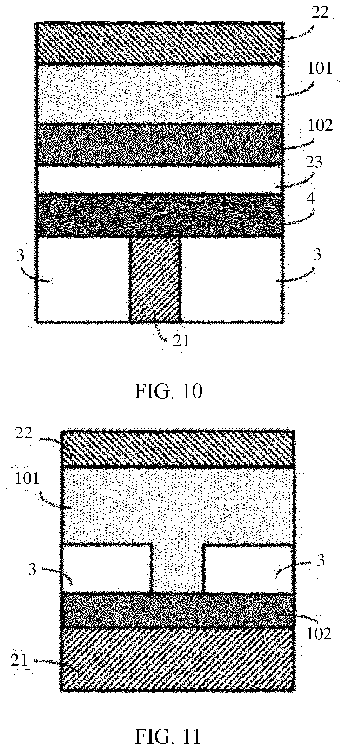

Further, as shown in FIG. 10, the phase-change storage unit of the T-shaped structure in this example may further include an intermediate electrode layer 23 and a gating layer 4. A first surface of the intermediate electrode layer 23 is in contact with the phase-change thin film 1, and a second surface of the intermediate electrode layer 23 is in contact with the gating layer 4. The phase-change thin film 1, the intermediate electrode layer 23, and the gating layer 4 are located between the bottom electrode layer 21 and the top electrode layer 22 as a whole. For example, in an up-down direction, the top electrode layer 22, the phase-change thin film 1, the intermediate electrode layer 23, the gating layer 4, and the bottom electrode layer 21 are sequentially disposed in a stacked manner.

The phase-change storage unit of this type may be prepared by using the following method.

Step 201: Form the insulation medium layer 3 on the substrate, etch the insulation medium layer 3 to form the through via, perform filling in the through via and form the bottom electrode layer 21, and make the top surface of the insulation medium layer 3 be flush with the top surface of the bottom electrode layer 21.

Step 202: Form the phase-change thin film 1 on the top surfaces of the insulation medium layer 3 and the bottom electrode layer 21 based on a preparation method of the phase-change thin film. In other words, the phase-change material layer 101 and the heterojunction layer 102 are sequentially formed on the top surfaces of the insulation medium layer 3 and the bottom electrode layer 21 based on a distribution sequence of the phase-change material layer 101 and the heterojunction layer 102 in the phase-change thin film 1, to obtain the phase-change thin film 1.

Step 203: Continue to form the top electrode layer 22 on the top surface of the phase-change thin film 1, to obtain the phase-change storage unit.

Further, when the phase-change storage unit includes the gating layer 4, the preparation method of the phase-change storage unit of the T-shaped structure further includes: Adaptively deposit the gating layer 4 and the intermediate electrode layer 23 based on specific arrangement of the gating layer 4 and specific arrangement of the intermediate electrode layer 23 in the phase-change storage unit.

For example, as shown above, after step 201 is sequentially performed, adaptive improvement is made when step 202 is performed. In this way, step 202 includes: Form the gating layer 4 on the top surfaces of the insulation medium layer 3 and the bottom electrode layer 21, then continue to form the intermediate electrode layer 23 on the gating layer 4, and form the phase-change thin film 1 on the intermediate electrode layer 23. Finally, step 203 is performed as described above.

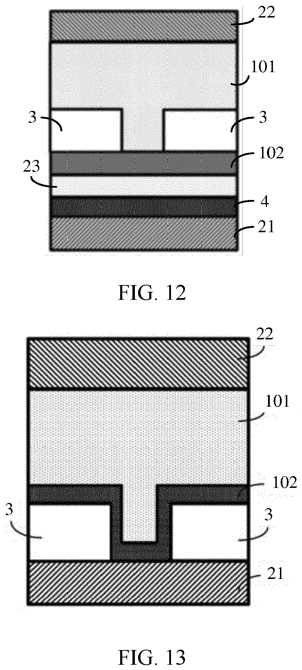

(3) In some possible implementations, an embodiment of this disclosure provides a phase-change storage unit of a U-shaped groove structure. As shown in FIG. 11 or FIG. 13, the phase-change storage unit of the U-shaped groove structure includes a phase-change thin film 1, a bottom electrode layer 21, a top electrode layer 22, and an insulation medium layer 3. In a top-down direction, the top electrode layer 22, the phase-change thin film 1, and the bottom electrode layer 21 are in contact sequentially, in other words, the bottom electrode layer 21 is formed on a top surface of a substrate, the phase-change thin film 1 is formed on a top surface of the bottom electrode layer 21, and the top electrode layer 22 is formed on a top surface of the phase-change thin film 1. The insulation medium layer 3 has a U-shaped groove, and the U-shaped groove is used to accommodate a phase-change material layer 101 and/or a heterojunction layer 102 of the phase-change thin film 1.

(3.1) In some examples, as shown in FIG. 11, the heterojunction layer 102 of the phase-change thin film 1 is located on the top surface of the bottom electrode layer 21, the insulation medium layer 3 having the U-shaped groove is located on the heterojunction layer 102, a part of the phase-change material layer 101 is located inside the U-shaped groove of the insulation medium layer 3 and is in contact with the heterojunction layer 102, and another part of the phase-change material layer 101 coats the insulation medium layer 3. The top electrode layer 22 coats a top surface of the insulation medium layer 3.

Further, as shown in FIG. 12, the phase-change storage unit of the U-shaped groove structure may further include an intermediate electrode layer 23 and a gating layer 4. A first surface of the intermediate electrode layer 23 is in contact with the phase-change thin film 1, a second surface of the intermediate electrode layer 23 is in contact with the gating layer 4, and the phase-change thin film 1, the intermediate electrode layer 23, and the gating layer 4 are located between the bottom electrode layer 21 and the top electrode layer 22 as a whole. For example, in an up-down direction, the heterojunction layer 102, the intermediate electrode layer 23, the gating layer 4, and the bottom electrode layer 21 are sequentially disposed in a stacked manner.

The phase-change storage unit of this type may be prepared by using the following method.

Step 311: Provide a clean substrate, form the bottom electrode layer 21 on a surface of the substrate, and spread the bottom electrode layer 21 on a top surface of the substrate.

Step 312: Form the heterojunction layer 102 on a surface of the bottom electrode layer 21, and overspread the heterojunction layer 102 on the top surface of the bottom electrode layer 21.

Step 313: Form the insulation medium layer 3 on the heterojunction layer 102, and overspread the insulation medium layer 3 on a top surface of the heterojunction layer 102; after the insulation medium layer 3 is deposited to be of a specific thickness, etch the insulation medium layer 3, to etch off a part that is of the insulation medium layer 3 and that corresponds to the U-shaped groove; and expose the heterojunction layer 102. In this way, the U-shaped groove can be formed in the insulation medium layer 3.

Step 314: Form the phase-change material layer 101, continue to deposit the phase-change material layer 101 to be of a specific thickness after the U-shaped groove is filled with the phase-change material layer 101, and tile the phase-change material layer 101 on the insulation medium layer 3.

Step 315: Form the top electrode layer 22 on a top surface of the phase-change material layer 101, to obtain the phase-change storage unit.

Further, when the phase-change storage unit includes the gating layer 4, the preparation method of the phase-change storage unit further includes: Adaptively deposit the gating layer 4 and the intermediate electrode layer 23 based on specific arrangement of the gating layer 4 and specific arrangement of the intermediate electrode layer 23 in the phase-change storage unit.

For example, as shown above, step 311 is sequentially performed, and then adaptive improvement is made when step 312 is performed. In this way, step 312 includes: First form the gating layer 4 on the surface of the bottom electrode layer 21, then continue to form the intermediate electrode layer 23 on the gating layer 4, form the heterojunction layer 102 on a surface of the intermediate electrode layer 23, and overspread the heterojunction layer 102 on a top surface of the intermediate electrode layer 23. Finally, step 313 to step 315 are performed sequentially based on the foregoing descriptions, and step 313 to step 315 are shown above.

(3.2) In some other examples, as shown in FIG. 13, the insulation medium layer 3 having the U-shaped groove is located on the bottom electrode layer 21, and the heterojunction layer 102 of the phase-change thin film 1 includes an intermediate groove part and a side tiled part, where the intermediate groove part has a U-shaped blind groove (that is, a bottom is of a closed type). The intermediate groove part of the heterojunction layer 102 is located in the U-shaped groove of the insulation medium layer 3, and a bottom surface of the intermediate groove part is in contact with the bottom electrode layer 21. The side tiled part of the heterojunction layer 102 is located on the top surface of the insulation medium layer 3, and the phase-change material layer 101 is located between the heterojunction layer 102 and the top electrode layer 22, in other words, a part of the phase-change material layer 101 fills in the U-shaped blind groove of the heterojunction layer 102, and another part of the phase-change material layer 101 is located on a top surface of the side tiled part of the heterojunction layer 102.

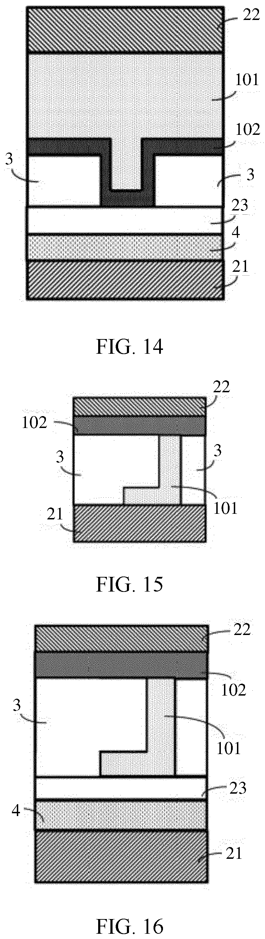

Further, as shown in FIG. 14, the phase-change storage unit of the U-shaped groove structure may further include the intermediate electrode layer 23 and the gating layer 4. A first surface of the intermediate electrode layer 23 is in contact with the phase-change thin film 1, a second surface of the intermediate electrode layer 23 is in contact with the gating layer 4, and the phase-change thin film 1, the intermediate electrode layer 23, and the gating layer 4 are located between the bottom electrode layer 21 and the top electrode layer 22 as a whole. For example, in an up-down direction, the heterojunction layer 102, the intermediate electrode layer 23, the gating layer 4, and the bottom electrode layer 21 are sequentially disposed in a stacked manner, where a part of the top surface of the intermediate electrode layer 23 is in contact with the heterojunction layer 102, and another part of the top surface is in contact with the insulation medium layer 3.

The phase-change storage unit of this type may be prepared by using the following method.

Step 321: Provide the clean substrate, form the bottom electrode layer 21 on the surface of the substrate, and overspread the bottom electrode layer 21 on the top surface of the substrate.

Step 322: Form the insulation medium layer 3 on the surface of the bottom electrode layer 21, and overspread the insulation medium layer 3 on the top surface of the bottom electrode layer 21; after the insulation medium layer 3 is deposited to be of a specific thickness, etch the insulation medium layer 3, to etch off a part that is of the insulation medium layer 3 and that corresponds to the U-shaped groove; and expose the bottom electrode layer 21. In this way, the U-shaped groove can be formed in the insulation medium layer 3.

Step 323: Form the heterojunction layer 102 on the insulation medium layer 3, overspread the heterojunction layer 102 on the top surface of the insulation medium layer 3, and after the heterojunction layer 102 is deposited to be of a specific thickness, etch the heterojunction layer 102, to etch off a part that is of the heterojunction layer 102 and that corresponds to the U-shaped blind groove. In this way, the U-shaped blind groove can be formed in the heterojunction layer 102.

Step 324: Form the phase-change material layer 101, continue to deposit the phase-change material layer 101 to be of a specific thickness after the U-shaped blind groove is filled with the phase-change material layer 101, and tile the phase-change material layer 101 on the heterojunction layer 102.

Step 325: Form the top electrode layer 22 on the top surface of the phase-change material layer 101, to obtain the phase-change storage unit.

Further, when the phase-change storage unit of this type of structure includes the gating layer 4, the preparation method of the phase-change storage unit further includes: Adaptively deposit the gating layer 4 and the intermediate electrode layer 23 based on the specific arrangement of the gating layer 4 and the specific arrangement of the intermediate electrode layer 23 in the phase-change storage unit.

For example, as shown above, step 321 is sequentially performed, and then adaptive improvement is made when step 322 is performed. In this way, step 322 includes: First form the gating layer 4 on the surface of the bottom electrode layer 21, then continue to form the intermediate electrode layer 23 on the gating layer 4, form the insulation medium layer 3 on the surface of the intermediate electrode layer 23, and overspread the insulation medium layer 3 on the top surface of the intermediate electrode layer 23; after the insulation medium layer 3 is deposited to be of a specific thickness, etch the insulation medium layer 3, to etch off the part that is of the insulation medium layer 3 and that corresponds to the U-shaped groove; and expose the intermediate electrode layer 23. Finally, step 323 to step 325 are performed sequentially based on the foregoing descriptions, and step 323 to step 325 are shown above.

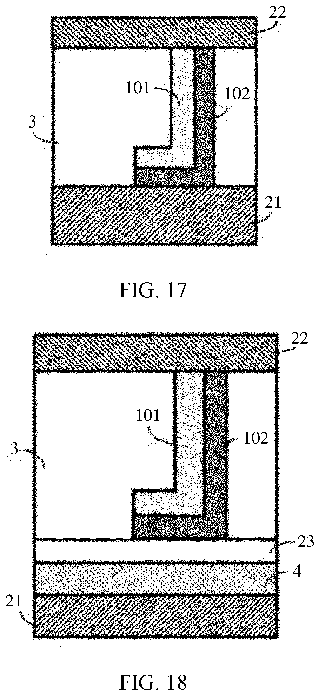

(4) In some possible implementations, an embodiment of this disclosure provides a phase-change storage unit of an L-shaped structure. As shown in FIG. 15 or FIG. 17, the phase-change storage unit of the L-shaped structure includes a phase-change thin film 1, a bottom electrode layer 21, a top electrode layer 22, and an insulation medium layer 3. The insulation medium layer 3 has an L-shaped hole, and the L-shaped hole is used to accommodate a phase-change material layer 101 and/or a heterojunction layer 102.

(4.1) In some possible implementations, as shown in FIG. 15, the phase-change material layer 101 is located in the L-shaped hole of the insulation medium layer 3 (that is, the phase-change material layer 101 is an L-shaped structure that adapts to the L-shaped hole), and a top surface and a bottom surface of the phase-change material layer 101 are flush with those of the insulation medium layer 3. In this case, in an up-down direction, the top electrode layer 22, the heterojunction layer 102, a whole formed by the phase-change material layer 101 and the insulation medium layer 3, and the bottom electrode layer 21 are sequentially disposed in a stacked manner.

Further, as shown in FIG. 16, the phase-change storage unit of the L-shaped structure may further include an intermediate electrode layer 23 and a gating layer 4. A first surface of the intermediate electrode layer 23 is in contact with the phase-change thin film 1, a second surface of the intermediate electrode layer 23 is in contact with the gating layer 4, and the phase-change thin film 1, the intermediate electrode layer 23, and the gating layer 4 are located between the bottom electrode layer 21 and the top electrode layer 22 as a whole. For example, in a down-up direction, the bottom electrode layer 21, the gating layer 4, and the intermediate electrode layer 23 are sequentially disposed in a stacked manner, and a whole formed by the phase-change material layer 101 and the insulation medium layer 3 is located on a top surface of the intermediate electrode layer 23.

The phase-change storage unit of the L-shaped structure may be prepared by using the following method.

Step 411: Provide a clean substrate, form the bottom electrode layer 21 on a surface of the substrate, and spread the bottom electrode layer 21 on a top surface of the substrate.

Step 412: Form the phase-change material layer 101 on a surface of the bottom electrode layer 21, and etch the phase-change material layer 101, so that the phase-change material layer 101 is of an L-shaped structure.

Step 413: Continue to form the insulation medium layer 3 on the bottom electrode layer 21, overspread the insulation medium layer 3 on a top surface of the bottom electrode layer 21 and make the insulation medium layer be filled in the L-shaped groove of the phase-change material layer 101, and after processing, make the insulation medium layer 3 be flush with a top surface of the phase-change material layer 101.

Step 414: Form the heterojunction layer 102 on the top surfaces of the insulation medium layer 3 and the phase-change material layer 101, and spread the heterojunction layer 102 on the top surfaces of the insulation medium layer 3 and the phase-change material layer 101.

Step 415: Form the top electrode layer 22 on a top surface of the heterojunction layer 102, to obtain the phase-change storage unit.

Further, when the phase-change storage unit of the L-shaped structure includes the gating layer 4, the preparation method of the phase-change storage unit further includes: Adaptively deposit the gating layer 4 and the intermediate electrode layer 23 based on specific arrangement of the gating layer 4 and specific arrangement of the intermediate electrode layer 23 in the phase-change storage unit.

For example, as shown above, step 411 is sequentially performed, and then adaptive improvement is made when step 412 is performed. In this way, step 412 includes: First form the gating layer 4 on the surface of the bottom electrode layer 21, continue to form the intermediate electrode layer 23 on the gating layer 4, form the phase-change material layer 101 on a surface of the intermediate electrode layer 23, and etch the phase-change material layer 101, so that the phase-change material layer 101 is of the L-shaped structure. Finally, step 413 to step 415 are performed sequentially based on the foregoing descriptions, and step 413 to step 415 are shown above.

(4.2) In some other examples, as shown in FIG. 17, both the phase-change material layer 101 and the heterojunction layer 102 are designed as L-shaped structures, and one of the phase-change material layer 101 and the heterojunction layer 102 is seated in an L-shaped groove of the other. For example, the phase-change material layer 101 is seated in an L-shaped groove of the heterojunction layer 102, the phase-change material layer 101 and the heterojunction layer 102 form the phase-change thin film 1 of an L-shaped structure, and the phase-change thin film 1 is seated in an L-shaped hole of the insulation medium layer 3. In this way, the phase-change thin film 1 and the insulation medium layer 3 are located between the top electrode layer 22 and the bottom electrode layer 21 as a whole.

Further, as shown in FIG. 18, the phase-change storage unit of the L-shaped structure may further include the intermediate electrode layer 23 and the gating layer 4. A first surface of the intermediate electrode layer 23 is in contact with the phase-change thin film 1, a second surface of the intermediate electrode layer 23 is in contact with the gating layer 4, and the phase-change thin film 1, the intermediate electrode layer 23, and the gating layer 4 are located between the bottom electrode layer 21 and the top electrode layer 22 as a whole. For example, in a down-up direction, the bottom electrode layer 21, the gating layer 4, and the intermediate electrode layer 23 are sequentially disposed in a stacked manner, and a whole formed by the phase-change thin film 1 and the insulation medium layer 3 is located on the top surface of the intermediate electrode layer 23.

The phase-change storage unit of the L-shaped structure may be prepared by using the following method.

Step 421: Provide the clean substrate, form the bottom electrode layer 21 on the surface of the substrate, and overspread the bottom electrode layer 21 on the top surface of the substrate.

Step 422: Form the heterojunction layer 102 on the surface of the bottom electrode layer 21, and etch the heterojunction layer 102, so that the heterojunction layer 102 is of the L-shaped structure; and continue to form the phase-change material layer 101, make the phase-change material layer 101 be filled and seated in the L-shaped groove of the heterojunction layer 102, and then etch the phase-change material layer 101, so that the phase-change material layer 101 is also of the L-shaped structure accordingly.

Step 423: Continue to form the insulation medium layer 3 on the bottom electrode layer 21, overspread the insulation medium layer 3 on the top surface of the bottom electrode layer 21 and make the insulation medium layer 3 be filled in the L-shaped groove of the phase-change material layer 101, and finally make the top surfaces of the insulation medium layer 3, the phase-change material layer 101, and the heterojunction layer 102 be flush with each other.

Step 424: Form the top electrode layer 22 on the top surfaces of the insulation medium layer 3, the phase-change material layer 101, and the heterojunction layer 102, to obtain the phase-change storage unit.

Further, when the phase-change storage unit of the foregoing structure further includes the gating layer 4, the preparation method of the phase-change storage unit further includes: Adaptively deposit the gating layer 4 and the intermediate electrode layer 23 based on the specific arrangement of the gating layer 4 and the specific arrangement of the intermediate electrode layer 23 in the phase-change storage unit.

For example, as shown above, step 421 is sequentially performed, and then adaptive improvement is made when step 422 and step 423 are performed. In this way, step 422 includes: First form the gating layer 4 on the surface of the bottom electrode layer 21, continue to form the intermediate electrode layer 23 on the gating layer 4, form the heterojunction layer 102 on the surface of the intermediate electrode layer 23, and etch the heterojunction layer 102, so that the heterojunction layer 102 is of the L-shaped structure; and then, continue to form the phase-change material layer 101, fill the phase-change material layer 101 in the L-shaped groove of the heterojunction layer 102, and then etch the phase-change material layer 101, so that the phase-change material layer 101 is also of the L-shaped structure accordingly. In this way, step 423 includes: Continue to form the insulation medium layer 3 on the intermediate electrode layer 23, overspread the insulation medium layer 3 on the top surface of the intermediate electrode layer 23 and make insulation medium layer 3 be filled in the L-shaped groove of the phase-change material layer 101, and finally make the top surfaces of the insulation medium layer 3, the phase-change material layer 101, and the heterojunction layer 102 be flush with each other.

Finally, step 424 is performed as described above.

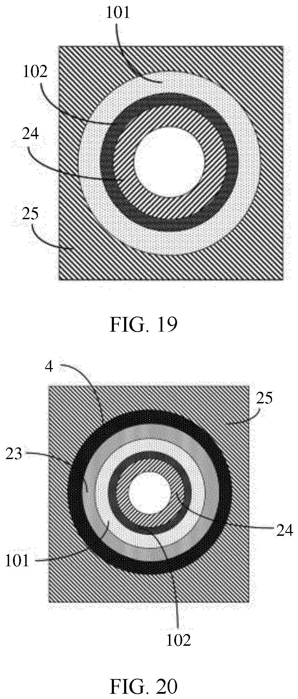

(5.1) In some possible implementations, as shown in FIG. 19, an embodiment of this disclosure provides a phase-change storage unit of a cylindrical structure. The phase-change storage unit includes a phase-change thin film 1, an inner electrode layer 24, and an outer electrode layer 25. The inner electrode layer 24, the phase-change thin film 1, and the outer electrode layer 25 are sequentially coated from inside to outside in a radial direction. Raw material composition of the inner electrode layer 24 and the outer electrode layer 25 may be the same as that of the foregoing bottom electrode layer 21 and the foregoing top electrode layer 22.

In some examples, as shown in FIG. 19, a phase-change material layer 101 coats an outside of a heterojunction layer 102, in other words, the heterojunction layer 102 coats an outside of the inner electrode layer 24 in a circumferential direction, the phase-change material layer 101 coats the outside of the heterojunction layer 102 in a circumferential direction, and the outer electrode layer 25 coats an outside of the phase-change material layer 101 in a circumferential direction.

In some other examples, the heterojunction layer 102 coats the outside of the phase-change material layer 101, in other words, the phase-change material layer 101 coats the outside of the inner electrode layer 24 in a circumferential direction, the heterojunction layer 102 coats the outside of the phase-change material layer 101 in a circumferential direction, and the outer electrode layer 25 coats the outside of the heterojunction layer 102 in a circumferential direction (which is not shown in the figure).

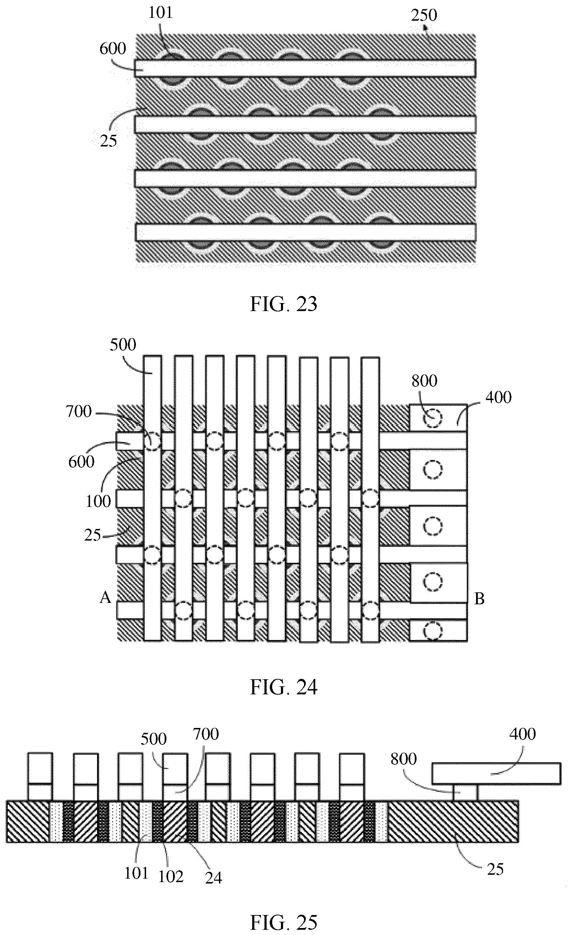

In the foregoing example, the inner electrode layer 24 located at a central location of the phase-change storage unit may be in a solid cylindrical shape, or may be in a circular annular shape shown in FIG. 19. A shape of the inner electrode layer 24 is randomly selected based on a preparation process condition. Regardless of which shape is selected for the inner electrode layer 24, when the inner electrode layer 24 is used for a phase-change storage array, and structural steps shown in FIG. 23 are performed, obtained array structures are also the same.

For the phase-change storage unit of the cylindrical structure in the foregoing example, an example in which the phase-change material layer 101 coats the outside of the heterojunction layer 102 is used to describe a preparation method of the phase-change storage unit of the structure. The method is shown as follows.

Step 511: Provide a clean substrate, form the outer electrode layer 25 of a specific thickness on a surface of the substrate, and spread the outer electrode layer 25 on a top surface of the substrate.

Step 512: Etch the outer electrode layer 25 to form the outer electrode layer 25 into an annular structure, and then form the heterojunction layer 102 on an inner wall of the outer electrode layer 25, where the formed heterojunction layer 102 is also of an annular structure.

Step 513: Polish an inner wall of the heterojunction layer 102, and then form the phase-change material layer 101 on the inner wall of the heterojunction layer 102, where the formed phase-change material layer 101 is also of an annular structure.

Step 514: Polish an inner wall of the phase-change material layer 101, and then form the inner electrode layer 24 on the inner wall of the phase-change material layer 101, where the inner electrode layer 24 may be formed into an annular structure, or may be formed into a solid cylindrical structure (that is, a round hole of the phase-change material layer 101 is filled).

When the heterojunction layer 102 coats the outside of the phase-change material layer 101, a corresponding preparation method of the phase-change storage unit is the same as the foregoing method. Differences lie in that step 1512 is changed as forming the phase-change material layer 101 on the inner wall of the outer electrode layer 25; step 1513 is changed as forming the heterojunction layer 102 on the inner wall of the phase-change material layer 101; and step 1514 is changed as forming the inner electrode layer 24 on the inner wall of the heterojunction layer 102.

(5.2) In some possible implementations, as shown in FIG. 20, an embodiment of this disclosure provides another phase-change storage unit of a cylindrical structure. The phase-change storage unit includes a phase-change thin film 1, an inner electrode layer 24, an intermediate electrode layer 23, a gating layer 4, and an outer electrode layer 25. The inner electrode layer 24, the phase-change thin film 1, the intermediate electrode layer 23, the gating layer 4, and the outer electrode layer 25 are sequentially coated from inside to outside in a radial direction.

In some examples, a phase-change material layer 101 coats an outside of a heterojunction layer 102, in other words, the heterojunction layer 102 coats an outside of the inner electrode layer 24 in a circumferential direction, the phase-change material layer 101 coats the outside of the heterojunction layer 102 in a circumferential direction, the intermediate electrode layer 23 coats an outside of the phase-change material layer 101 in a circumferential direction, the gating layer 4 coats an outside of the intermediate electrode layer 23 in a circumferential direction, and the outer electrode layer 25 coats an outside of the intermediate electrode layer 23 in a circumferential direction.

In some other examples, the heterojunction layer 102 coats the outside of the phase-change material layer 101, in other words, the phase-change material layer 101 coats the outside of the inner electrode layer 24 in a circumferential direction, the heterojunction layer 102 coats the outside of the phase-change material layer 101 in a circumferential direction, the intermediate electrode layer 23 coats the outside of the heterojunction layer 102 in a circumferential direction, and the gating layer 4 coats the outside of the intermediate electrode layer 23 in a circumferential direction, the outer electrode layer 25 coats the outside of the intermediate electrode layer 23 in a circumferential direction.

In the foregoing example, the inner electrode layer 24 located at a central location of the phase-change storage unit may be in a solid cylindrical shape, or may be in a circular annular shape.

For the phase-change storage unit of the cylindrical structure in the foregoing example, an example in which the phase-change material layer 101 coats the outside of the heterojunction layer 102 is used to describe a preparation method of the phase-change storage unit of the structure. The method is shown as follows.

Step 521: Provide a clean substrate, form the outer electrode layer 25 of a specific thickness on a surface of the substrate, and spread the outer electrode layer 25 on a top surface of the substrate.

Step 522: Etch the outer electrode layer 25 to form the outer electrode layer 25 into an annular structure, and then form the heterojunction layer 102 on an inner wall of the outer electrode layer 25, where the formed heterojunction layer 102 is also of an annular structure.

Step 523: Polish an inner wall of the heterojunction layer 102, and then form the phase-change material layer 101 on the inner wall of the heterojunction layer 102, where the formed phase-change material layer 101 is also of an annular structure.

Step 524: Polish an inner wall of the phase-change material layer 101, and then form the intermediate electrode layer 23 on the inner wall of the phase-change material layer 101, where the formed intermediate electrode layer 23 is also of an annular structure.

Step 525: Polish an inner wall of the intermediate electrode layer 23, and then form the gating layer 4 on the inner wall of the intermediate electrode layer 23, where the formed gating layer 4 is also of an annular structure.

Step 526: Polish an inner wall of the gating layer 4, and then form the inner electrode layer 24 on the inner wall of the gating layer 4, where the inner electrode layer 24 may be formed into an annular structure, or may be formed into a solid cylindrical structure (that is, a round hole of the phase-change material layer 101 is filled).

When the heterojunction layer 102 coats the outside of the phase-change material layer 101, a corresponding preparation method of the phase-change storage unit is the same as the foregoing method. Differences lie in that step 522 is changed as forming the phase-change material layer 101 on the inner wall of the outer electrode layer 25; step 523 is changed as forming the heterojunction layer 102 on the inner wall of the phase-change material layer 101; and step 524 is changed as forming the intermediate electrode layer 23 on the inner wall of the heterojunction layer 102.

For the preparation method of the phase-change storage unit provided in this embodiment of this disclosure, as described above, the preparation method of the phase-change storage unit includes: preparing the phase-change thin film 1. The preparing the phase-change thin film 1 further includes: forming the phase-change material layer 101 and the heterojunction layer 102 separately, and contacting the phase-change material layer 101 with the heterojunction layer 102. A process includes: First form the phase-change material layer 101, and then form the heterojunction layer 102 on the phase-change material layer 101; or first form the heterojunction layer 102, and then form the phase-change material layer 101 on the heterojunction layer 102.

When forming the phase-change material layer 101, form the phase-change material layer 101 by using the foregoing phase-change material and by using a thin film deposition process. When forming the heterojunction layer 102, form the heterojunction layer 102 by using the foregoing heterojunction material and by using the thin film deposition process.

As described above, the thin film deposition process applicable to this embodiment of this disclosure includes but is not limited to the following: an atomic layer deposition (atomic layer deposition, ALD) process, a physical vapor deposition (Physical Vapor Deposition, PVD) process, and a chemical vapor deposition (Chemical Vapor Deposition, CVD) process, for example, a plasma enhanced chemical vapor deposition (Plasma Enhanced Chemical Vapor Deposition, PECVD) process, a magnetron sputtering process, and an electron beam evaporation process.

The magnetron sputtering is a type of the physical vapor deposition process, and has advantages such as being easy to control, a large film coating area, strong adhesion, and a wide range of preparation objects. For example, in this embodiment of this disclosure, the magnetron sputtering process may be used to form the phase-change material layer 101 and the heterojunction layer 102.

According to another aspect, an embodiment of this disclosure further provides a phase-change storage array, where the phase-change storage array includes any one of the foregoing phase-change storage units 100.

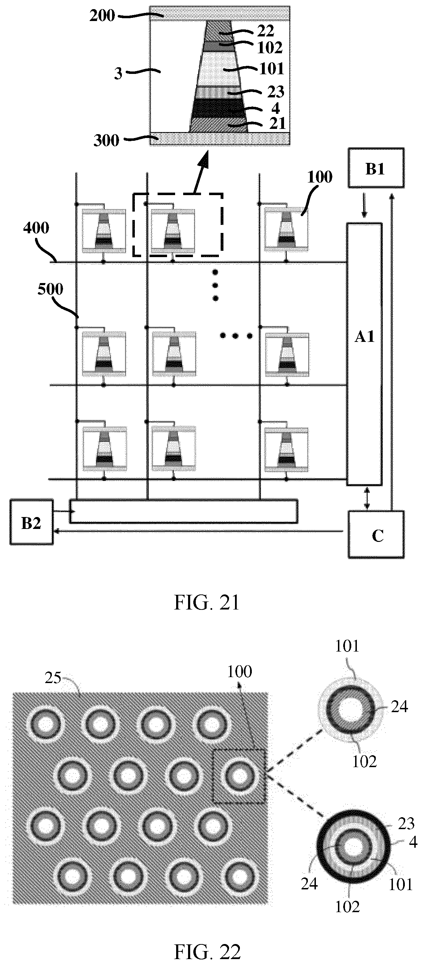

In some examples, structures of a plurality of phase-change storage units 100 included in the phase-change storage array are the foregoing confined structure, T-shaped structure, U-shaped groove structure, or L-shaped structure. FIG. 21 shows a corresponding phase-change storage array when the phase-change storage unit 100 is of the confined structure.

In an example, one phase-change storage unit 100 shown in FIG. 21 may be prepared by using the following method:

Provide a substrate including a metal layer as a bit line layer 300, where a material of the metal layer may be W.

Clean, by alternately using acetone and ethanol, the substrate including the bit line layer 300, to remove various impurities such as organic substances, oxides, and metal ions on a surface of the substrate; and bake the substrate in an oven for 20 minutes at 80°C, so that the substrate is fully dry.

Grow a bottom electrode 21, a gating layer 4, an intermediate electrode layer 23, a phase-change material layer 101, a heterojunction layer 102, and a top electrode layer 22 sequentially by using a magnetron sputtering method.

Etch each film layer above the bit line layer 300 by using a photoetching and etching process until the bit line layer 300 is exposed.

Deposit an insulation medium layer 3 by using a PECVD process until all film layers are completely coated, where for example, the insulation medium layer 3 is made of $Si_3N_4$.

Remove a redundant part of the insulation medium layer 3 by using a polishing process until the top electrode layer 22 is exposed, and finally grow a metal layer on the top electrode layer 22 as a word line layer 200.

In this example, materials of the bottom electrode layer 21 and the top electrode layer 22 are both TiN, and an operation parameter of magnetron sputtering is: A sputtering power supply is a DC power supply, a sputtering background vacuum is $8\times10^{-5}$ Pa to $2\times10^{-4}$ Pa, sputtering gas is Ar, and a sputtering atmospheric pressure is 3 mTorr to 6 mTorr.

A magnetron sputtering parameter of the heterojunction layer 101 and the phase-change material layer 102 is: A substrate temperature is 150°C to 300°C during sputtering. The heterojunction layer 101 uses an ScTe target material, and a sputtering power is 10 W to 20 W. The phase-change material layer uses an $Sb_2Te_3$ target material, and a sputtering power is 7 W to 30 W. A magnetron sputtering parameter of the top electrode layer 22 is: A substrate temperature is 20°C to 40°C, a TiN target material is used, and a sputtering power is 50 W to 250 W. In addition, the etching process in this example is reactive-ion etching.

In addition to the plurality of phase-change storage units 100, the phase-change storage array further includes the word line layer 200, the bit line layer 300, a plurality of word lines 400, and a plurality of bit lines 500.

The plurality of phase-change storage units 100 are arranged by array. For example, any four adjacent phase-change storage units 100 form a rectangular shape, a top electrode layer 22 of each phase-change storage unit 100 is connected to one word line layer 200, and a bottom electrode layer 21 of each phase-change storage unit 100 is connected to one bit line layer 300.

The plurality of word lines 400 are sequentially arranged by row, the plurality of bit lines 500 are sequentially arranged by column, and the plurality of word lines 400 cooperate with the plurality of bit lines 500 to form an array that adapts to the plurality of phase-change storage units 100.

Each phase-change storage unit 100 is located in a matrix subunit including the word line 400 and the bit line 500. The top electrode layer 22 of each phase-change storage unit 100 is connected to a bit line 500 of a corresponding column by using a word line layer 200 connected to the top electrode layer 22, and the bottom electrode layer 21 of each phase-change storage unit 100 is connected to a word line 400 of a corresponding row by using a bit line layer 300 connected to the bottom electrode layer 21.

When the phase-change storage array is applied, the plurality of word lines 400 arranged by row are connected to a row selection circuit A1, and the row selection circuit A1 can be driven by a row voltage control circuit B1. The plurality of bit lines 500 arranged by column are connected to a column selection circuit A2, and the column selection circuit A2 can be driven by a column voltage control circuit B2.

In application, a read/write circuit C is separately connected to the row voltage control circuit B1 or the column voltage control circuit B2. In this way, the read/write circuit C controls the row selection circuit A1 or the column selection circuit A2 by receiving a command of a processor and by using the row voltage control circuit B1 or the column voltage control circuit B2, to perform read and write operations on a selected phase-change storage unit 100.

In some other examples, the plurality of phase-change storage units 100 included in the phase-change storage array are the foregoing phase-change storage units 100 of the cylindrical structure. These phase-change storage units 100 are located at a same layer. Refer to FIG. 22 and FIG. 23. Outer electrode layers 25 of these phase-change storage units 100 are connected to each other to form an integral electrode base 250. In other words, the electrode base 250 may be shared by the plurality of phase-change storage units 100.

In this example, as shown in FIG. 22 to FIG. 25, in addition to the plurality of phase-change storage units 100, the phase-change storage array further includes a plurality of insulation media 600, a plurality of first metal connection columns 700, a plurality of second metal connection columns 800, the plurality of word lines 400, and the plurality of bit lines 500.

In terms of specific arrangement of components, the plurality of phase-change storage units 100 are arranged by array. For example, any three adjacent phase-change storage units 100 can form an equilateral triangle.

The insulation medium 600 is in a strip shape, for example, a rectangular strip shape structure. Any insulation medium 600 runs through a plurality of phase-change storage units 100 located in a same row. An example in which an inner electrode layer 24 is in an annular structure is used, in a radial direction, a width of the insulation medium 600 is equal to or slightly greater than an inner circle diameter of the inner electrode layer 24. In an axial direction, a top surface and a bottom surface of the insulation medium 600 are flush with a top surface and a bottom surface of the phase-change storage unit 100.

Any phase-change storage unit 100 is correspondingly connected to one first metal connection column 700, where the first metal connection column 700 is, for example, in a cylindrical shape, a bottom of the first metal connection column 700 is fixed on an insulation medium 600 at a corresponding position, and the bottom of the first metal connection column 700 is further connected to an inner electrode layer 24 corresponding to the phase-change storage unit 100 (which is implemented by making a diameter of the first metal connection column 700 greater than the width of the insulation medium 600 and making the diameter of the first metal connection column 700 less than an outer diameter of the heterojunction layer 102, to prevent a short circuit of the heterojunction layer 102).

Phase-change storage units 100 located in a same column correspond to one bit line 500, and the bit line 500 is connected to a top of a first metal connection column 700 of the phase-change storage units 100 in the same column.

The plurality of second metal connection columns 800 (where the second metal connection column 800 is, for example, in a cylindrical shape) are connected to the outer electrode layer 25 shared by the plurality of phase-change storage units 100, in other words, to a position that is on the electrode base 250 and at which the phase-change storage unit 100 is not disposed, the plurality of second metal connection columns 800 are arranged into one column, and each word line 400 is connected to a top of one second metal connection column 800.

The foregoing phase-change storage array having the single-layer phase-change storage units 100 may be prepared by using the following method.

Refer to FIG. 22. A first intermediate array is provided. In the first intermediate array, the plurality of phase-change storage units 100 are arranged by array, so that any three adjacent phase-change storage units 100 form an equilateral triangle. The phase-change storage unit 100 may not include the gating layer 4, or may include the gating layer 4. The following uses an example in which the phase-change storage unit 100 does not include the gating layer 4 to describe a preparation method of the phase-change storage array.

Refer to FIG. 23. Holes are drilled on the first intermediate array to form a plurality of rows of filling holes, and then the insulation medium 600 is filled in each row of filling holes to form a second intermediate array. In a radial direction, a width of the filling hole is equal to or slightly greater than the inner circle diameter of the inner electrode layer 24. In an axial direction, the filling hole runs through a top and a bottom of the first intermediate array.

Refer to FIG. 24. The plurality of first metal connection columns 700 are formed on the second intermediate array, and the bottom of the first metal connection column 700 is fastened to the insulation medium 600. In addition, the bottom of the first metal connection column 700 is further connected to the inner electrode layer 24 of the corresponding phase-change storage unit 100. Then, a strip-shape metal layer is connected to the tops of the first metal connection columns 700 located in the same column, to be used as the bit line 500.

The second metal connection column 800 is separately formed on regions that are on the outer electrode layer 25 and that are isolated by the insulation medium 600, and the plurality of second metal connection columns 800 are arranged into one column. Then, another strip-shape metal layer is connected to tops of the plurality of second metal connection columns 800, to be used as the word line 400, and finally the foregoing phase-change storage array is formed. For a structure of the phase-change storage array, reference may be further made to FIG. 25.

In application, different phase-change storage units 100 are selected by using the word line 400 and the bit line 500 to perform read and write operations, an erase operation is performed by applying a narrow and high nanosecond-level electrical pulse, a write operation is performed by using a wide and low nanosecond-level electrical pulse, and finally a resistance state after the operations is read at a low voltage. When the phase-change storage units 100 cooperate with the gating layer 4, impact of a leakage current of the erase and write operations on an adjacent phase-change storage unit 100 may be prevented.

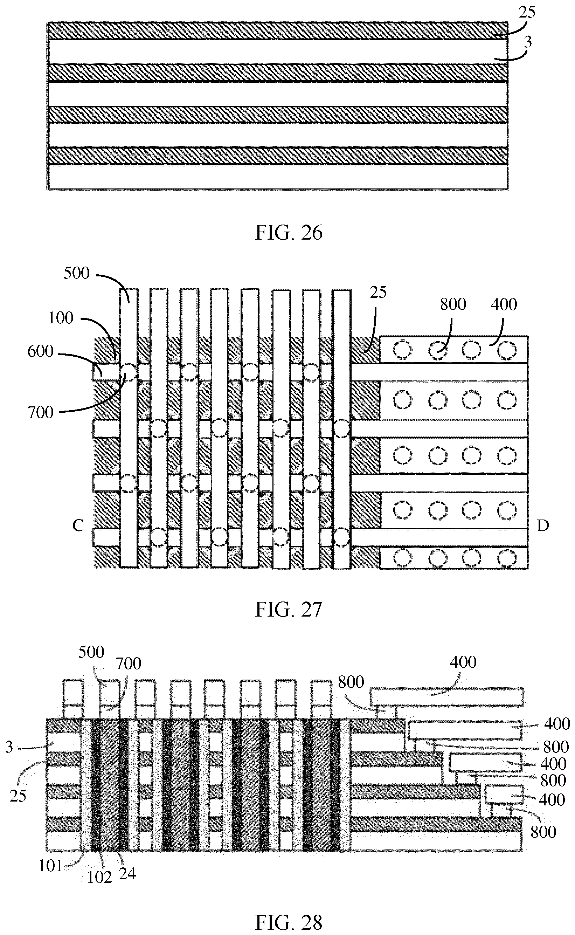

The foregoing describes a structure in which a plurality of phase-change storage units 100 in the phase-change storage array are located at a same layer. In some other examples, as shown in FIG. 26 to FIG. 28, the phase-change storage array may further include a plurality of phase-change storage units 100 located at different layers, that is, the phase-change storage array includes a plurality of layers of phase-change storage subarrays. The plurality of layers of phase-change storage subarrays are sequentially distributed in a top-down direction and formed into a step shape, and two adjacent layers of phase-change storage subarrays are separated by the insulation medium layer 3. In this embodiment of this disclosure, this type of the phase-change storage array is referred to as a three-dimensional stacking storage array.

In the three-dimensional stacking storage array, a structure of each layer of phase-change storage subarray is the same as the foregoing structure of the phase-change storage array whose phase-change storage units 100 are located at the same layer, and details are not described herein again.

When the three-dimensional stacking storage array including the plurality of layers of phase-change storage subarrays is prepared, a preparation method is as follows.

Refer to FIG. 26. A plurality of outer electrode layers 25 and a plurality of insulation medium layers 3 are alternately stacked, and the outer electrode layers 25 and insulation medium layers 900 are disposed in a stacked manner in a top-down direction and distributed into a step shape. In this way, each outer electrode layer 25 is used as the electrode base 250.

Refer to FIG. 27 and FIG. 28. A plurality of phase-change storage units 100 are formed at each outer electrode layer 25, that is, at each electrode base 250, to form a plurality of layers of first intermediate arrays. A structure of the first intermediate array is the same as the foregoing first intermediate array structure, and details are not described herein again. With reference to the foregoing method, each layer of the first intermediate array is processed to finally form the plurality of layers of phase-change storage subarrays. Correspondingly, the second metal connection column 800 is separately formed on regions that are isolated by the insulation medium 600 and that are on outer electrode layers 25 corresponding to different layers of steps. Strip-shape metal layers are connected one by one to the second metal connection columns 800, to be used as word lines 400; and finally the three-dimensional stacked storage array having the plurality of layers of phase-change storage subarrays shown in FIG. 28 is formed.

In application, different phase-change storage units 100 are selected by using the word line 400 and the bit line 500 to perform the read and write operations, the erase operation is performed by applying the narrow and high nanosecond-level electrical pulse, the write operation is performed by using the wide and low nanosecond-level electrical pulse, and finally the resistance state after the operations is read at the low voltage. When the phase-change storage unit 100 cooperates with the gating layer 4, the impact of the leakage current of the erase and write operations on the adjacent phase-change storage unit 100 may be prevented.

Further, for multi-layer design of the phase-change storage subarrays, that is, one layer of word line 400 may be added by horizontally increasing a width of a tiny step, and different layers of word lines 400 are selected to control different layers of phase-change storage units 100, to achieve effect of three-dimensional high-density storage without increasing a storage area to a maximum extent.

According to still another aspect, an embodiment of this disclosure further provides a phase-change memory, where the phase-change memory includes a plurality of any one of the foregoing phase-change storage units. The phase-change memory in this embodiment of this disclosure may be considered as a phase-change storage chip.

Based on use of the foregoing phase-change storage unit, the phase-change memory provided in this embodiment of this disclosure has at least the following advantages: high stability, good repeatability, a high read/write speed, a high memory density, low costs, and the like.

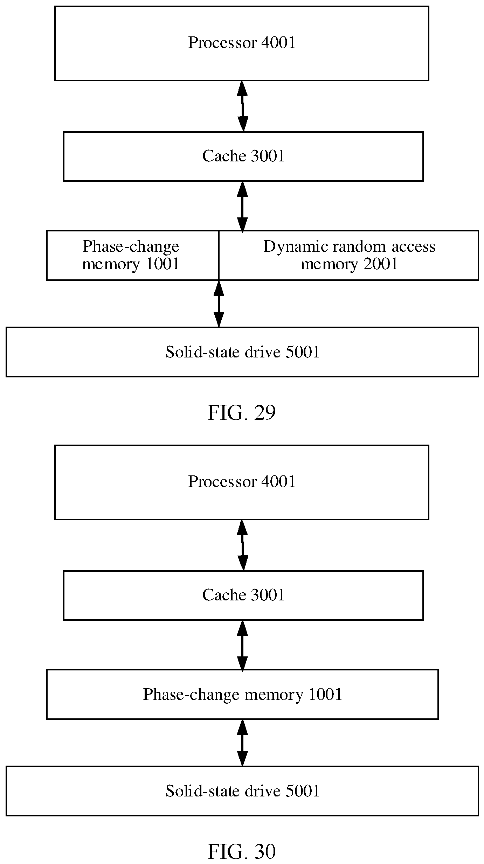

FIG. 29 provides a schematic diagram of an application scenario of a phase-change memory including a phase-change storage unit. The application scenario includes the phase-change memory 1001, a dynamic random access memory 2001, a cache 3001, a processor 4001, and a solid-state drive 5001 that are communicatively connected. During application, the phase-change memory 1001 and the dynamic random access memory 2001 can be together used as a hybrid memory.

FIG. 30 provides a schematic diagram of another application scenario of a phase-change memory including a phase-change storage unit. The application scenario includes the phase-change memory 1001, a cache 3001, a processor 4001, and a solid-state drive 5001 that are communicatively connected. During application, the phase-change memory 100 is independently used as a memory.

A structure of the phase-change memory in this embodiment of this disclosure includes but is not limited to a 1R structure, a 1T1R structure, a 1D1R structure, or the like.

The phase-change memory including the phase-change storage unit in this embodiment of this disclosure can collaborate with a dynamic random access memory, and can even replace the dynamic random access memory as a memory. This is conducive to increasing a memory density (for example, a high density of $4F^2$), and is easy to perform 3-dimensional integration with a gating device and be compatible with a COMS process, and reduces memory costs. This also avoids a power consumption problem caused by continuous refresh of the dynamic random access memory.

According to yet another aspect, an embodiment of this disclosure further provides a storage device. The storage device includes a controller and any one of the foregoing phase-change memories, and the controller is configured to store data in a phase-change memory device. The controller reads and writes the data stored in the storage device, and interacts and communicates with an external interface. The storage device may be configured to store various types of data, where the data may be contact data, phone book data, a message, a picture, a video, or may be instruction data.

The storage device in this embodiment of this disclosure may be set to various types, for example, including but not limited to a memory, a hard disk, a magnetic disk, and an optical disc.

According to still yet another aspect, an embodiment of this disclosure further provides an electronic device. The electronic device includes a processor, and the foregoing phase-change memory or the foregoing storage device, where the phase-change memory is configured to store data accessed by the processor.

For example, the electronic device includes but is not limited to a computer, a mobile phone, a printer, a camera, a music playback device, a digital broadcast device, a message transceiver device, a game control device, a medical device, a fitness device, a personal digital assistant, and the like.

For terms "each item", "a plurality of items", "any one item", and the like used in embodiments of this disclosure, "a plurality of items" includes two or more items, "each item" is each of a corresponding plurality of items, and "any one item" is any one of a corresponding plurality of items.

The foregoing descriptions are merely example embodiments of this application, but are not intended to limit this application. Any modification, equivalent replacement, or improvement made without departing from the spirit and principle of this application should fall within the protection scope of this application.

**Claims**

1. A phase-change storage unit, wherein the phase-change storage unit comprises a phase-change thin film (1), the phase-change thin film (1) comprises a phase-change material layer (101) and a heterojunction layer (102), and the phase-change material layer (101) is in contact with the heterojunction layer (102);

   the phase-change material layer (101) is formed by using a phase-change material, and the heterojunction layer (102) is formed by using a heterojunction material; and
   a lattice mismatch degree between the heterojunction material and the phase-change material is less than or equal to 20%, a contact crystal surface of the heterojunction material and a contact crystal surface of the phase-change material have a same lattice angle, and a melting point of the heterojunction material is greater than a melting point of the phase-change material.

2. The phase-change storage unit according to claim 1, wherein the heterojunction material and the phase-change material each are a hexagonal system material, and a length difference between an a axis of the heterojunction material and an a axis of the phase-change material is less than or equal to 20%.

3. The phase-change storage unit according to claim 1, wherein the heterojunction material is a hexagonal system material, the phase-change material is a cubic system material, a length of an a axis of the heterojunction material is defined as $a_1$, a length of an a axis of the phase-change material is defined as $a_2$, and a difference between $a_1$ and $\sqrt{2}a_2$ is less than or equal to 20%.

4. The phase-change storage unit according to claim 1, wherein a thickness of the phase-change material layer (101) is 2 nm to 100 nm; and
   a thickness of the heterojunction layer (102) is 2 nm to 20 nm.

5. The phase-change storage unit according to claim 1, wherein the phase-change material is one of a doped or an undoped Ge-Te binary compound, a doped or an undoped Sb-Te binary compound, a doped or an undoped Bi-Te binary compound, a doped or an undoped Ge-Sb-Te ternary compound, a doped or an undoped Ga-Sb binary compound, and doped or undoped Sb; and
the heterojunction material is an M-Te compound, wherein M is a transition metal element.

6. The phase-change storage unit according to claim 5, wherein M is Ti, Zr, Pd, Cd, Mo, Mn, Ir, Rn, Pt, Sc, Ni, Ta, or Zn.

7. The phase-change storage unit according to claim 5, wherein when the phase-change material is a doped material, a doping element is selected from at least one of C, N, Si, B, Sc, Ti, Y, Zr, Hf, V, Ta, W, Cu, Zn, and In.

8. The phase-change storage unit according to any one of claims 1 to 7, wherein the phase-change storage unit further comprises a bottom electrode layer (21), a top electrode layer (22), and an insulation medium layer (3);

the phase-change thin film (1) is located between the bottom electrode layer (21) and the top electrode layer (22); and
the insulation medium layer (3) is used to provide an insulation isolation function for the phase-change storage unit.

9. The phase-change storage unit according to claim 8, wherein the phase-change storage unit further comprises an intermediate electrode layer (23) and a gating layer (4);

a first surface of the intermediate electrode layer (23) is in contact with the phase-change thin film (1), and a second surface of the intermediate electrode layer (23) is in contact with the gating layer (4); and
the phase-change thin film (1), the intermediate electrode layer (23), and the gating layer (4) are located between the bottom electrode layer (21) and the top electrode layer (22) as a whole.

10. The phase-change storage unit according to claim 8 or 9, wherein the phase-change storage unit is of a confined structure, a T-shaped structure, a U-shaped groove structure, or an L-shaped structure.

11. The phase-change storage unit according to any one of claims 1 to 7, wherein the phase-change storage unit is of a cylindrical structure, and the phase-change storage unit further comprises an inner electrode layer (24) and an outer electrode layer (25); and the inner electrode layer (24), the phase-change thin film (1), and the outer electrode layer (25) are sequentially coated from inside to outside in a radial direction.

12. The phase-change storage unit according to any one of claims 1 to 7, wherein the phase-change storage unit is of a cylindrical structure, and the phase-change storage unit further comprises an inner electrode layer (24), an intermediate electrode layer (23), a gating layer (4), and an outer electrode layer (25); and
the inner electrode layer (24), the phase-change thin film (1), the intermediate electrode layer (23), the gating layer (4), and the outer electrode layer (25) are sequentially coated from inside to outside in a radial direction.

13. A phase-change storage array, wherein the phase-change storage array comprises the phase-change storage unit according to any one of claims 1 to 12.

14. A phase-change memory, wherein the phase-change memory comprises the phase-change storage unit according to any one of claims 1 to 12 or the phase-change storage array according to claim 13.

15. An electronic device, wherein the electronic device comprises a processor and the phase-change memory according to claim 14; and
the phase-change memory is configured to store data accessed by the processor.

16. A preparation method of a phase-change storage unit, wherein the phase-change storage unit is the phase-change storage unit according to any one of claims 1 to 12;

the preparation method of the phase-change storage unit comprises: preparing a phase-change thin film (1); and
the preparing a phase-change thin film (1) comprises: forming a phase-change material layer (101) and a heterojunction layer (102) separately, and contacting the phase-change material layer (101) with the heterojunction layer (102).

17. The preparation method of the phase-change storage unit according to claim 16, wherein the phase-change material layer (101) and the heterojunction layer (102) are separately formed by using a thin film deposition process.

18. The preparation method of the phase-change storage unit according to claim 17, wherein the thin film deposition process is an atomic layer deposition process, a physical vapor deposition process, a chemical vapor deposition process, or a plasma enhanced chemical vapor deposition process.

FIG. 1

FIG. 2

FIG. 3

FIG. 4

FIG. 5

FIG. 6

FIG. 7

FIG. 8

FIG. 9

22

101

102

23

4

3

3

21

FIG. 10

22

101

3

3

21

102

FIG. 11

FIG. 12

FIG. 13

FIG. 14

FIG. 15

FIG. 16

FIG. 17

FIG. 18

FIG. 19

FIG. 20

FIG. 21

FIG. 22

FIG. 23

FIG. 24

FIG. 25

FIG. 26

FIG. 27

FIG. 28

FIG. 29

FIG. 30

<table>
<tr><td colspan="2" align="center">**INTERNATIONAL SEARCH REPORT**</td><td>International application No.</td></tr>
<tr><td colspan="2"></td><td>**PCT/CN2022/097453**</td></tr>
</table>

**A. CLASSIFICATION OF SUBJECT MATTER**

H01L 45/00(2006.01)i; H01L 27/24(2006.01)i

According to International Patent Classification (IPC) or to both national classification and IPC

**B. FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNTXT; CNABS; CNKI; VEN; USTXT; WOTXT; EPTXT: 相变, 存储, 记忆, 记录, 晶格, 失配, 间距, 晶面, 取向, 夹角, 外延, 熔点, 超晶格, 模板, 模版, 结晶, 扩散, phase change, memory, storage, crystal lattice, mismatch, dismatch, space, lattice plane, crystal face, orientation, angle, epitax+, melting point, superlattice, template, diffus+

**C. DOCUMENTS CONSIDERED TO BE RELEVANT**

| Category* | Citation of document, with indication, where appropriate, of the relevant passages | Relevant to claim No. |
|---|---|---|
| PX | CN 113140674 A (HUAWEI TECHNOLOGIES CO., LTD.) 20 July 2021 (2021-07-20) description, paragraphs [0002]-[0102], and figures 1-10 | 1-18 |
| X | WO 2020247038 A1 (SANDISK TECHNOLOGIES LLC) 10 December 2020 (2020-12-10) description, paragraphs [0002]-[0069], and figures 1A-5 | 1-18 |
| X | CN 108987567 A (SHENZHEN UNIVERSITY) 11 December 2018 (2018-12-11) description, paragraphs [0002]-[0062], and figures 1-4 | 1-18 |
| A | CN 108666416 A (SHANGHAI INSTITUTE OF MICROSYSTEM AND INFORMATION TECHNOLOGY, CHINESE ACADEMY OF SCIENCES) 16 October 2018 (2018-10-16) entire document | 1-18 |
| A | CN 103794723 A (SHANGHAI INSTITUTE OF MICROSYSTEM AND INFORMATION TECHNOLOGY, CHINESE ACADEMY OF SCIENCES) 14 May 2014 (2014-05-14) entire document | 1-18 |

☐ Further documents are listed in the continuation of Box C.   ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **12 July 2022** | **22 July 2022** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**Information on patent family members**

International application No.

**PCT/CN2022/097453**

| Patent document cited in search report | | | Publication date (day/month/year) | Patent family member(s) | | | Publication date (day/month/year) |
|---|---|---|---|---|---|---|---|
| CN | 113140674 | A | 20 July 2021 | None | | | |
| WO | 2020247038 | A1 | 10 December 2020 | US | 2020388752 | A1 | 10 December 2020 |
| | | | | US | 10868245 | B1 | 15 December 2020 |
| CN | 108987567 | A | 11 December 2018 | None | | | |
| CN | 108666416 | A | 16 October 2018 | CN | 108666416 | B | 30 June 2020 |
| CN | 103794723 | A | 14 May 2014 | None | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110655982